# EUROPEAN PATENT APPLICATION

(11) **EP 4 575 637 A1**
(43) Date of publication of application: **25.06.2025**
(21) Application number: 23218493.7
(22) Date of filing: 20.12.2023
(51) Int. Cl.: G03F 7/00

(54) **METHOD AND APPARATUS FOR ASSESSING A SAMPLE SURFACE, METHOD OF SCANNING A SAMPLE SURFACE, AND CHARGED PARTICLE ASSESSMENT APPARATUS**

(71) Applicant: ASML Netherlands B.V., 5500 AH Veldhoven (NL)
(72) Inventor: MAASSEN, Martinus, Gerardus, Johannes, Maria, 5500 AH Veldhoven (NL)
(74) Representative: ASML Netherlands B.V.

(57) **Abstract**

The present disclosure provides methods and apparatus relating to assessing a sample surface using charged particles. In one arrangement, a method comprises, at a first region of a sample surface on which is an intended pattern, relative scanning a beam over an elongate row portion of the intended pattern along a first direction to generate a row data set. At a second region of the sample surface on which is a repeat of the intended pattern, the beam is relative scanned over an elongate column portion of the intended pattern along a second direction to generate a column data set. The row data set and the column data set are processed to compare between the row data set and the column data set a common portion of the intended pattern to assess the common portion.

## Description

### FIELD

The present disclosure relates to methods and apparatus for assessing a sample surface using charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment (such as inspection and/or measurement) of a surface of a substrate, or other object/material, is an important process during and/or after its manufacture.

Pattern assessment e.g. inspection apparatuses with a charged particle beam have been used to assess objects, which may be referred to as samples, for example to detect pattern defects. These apparatuses typically use electron microscopy techniques, such as a scanning electron microscope (SEM). In a design of SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection apparatus may obtain an image representing characteristics of the material structure of the surface of the sample.

Assessment of samples such us for inspection may comprise comparing a portion of an expected pattern in one region of a sample (e.g., in a first die) with a corresponding portion of the same pattern in a different region of the sample (e.g., in a second die) to detect defects in the pattern. To ensure that a desired portion of the pattern can be compared properly it may be necessary to scan a larger than necessary area of the sample surface to allow for scanning inaccuracies. Scanning a larger area than necessary, which may be referred to as an overscan, reduces throughput and is therefore undesirable.

### SUMMARY

It is an object of the present disclosure to provide methods and apparatus that improve throughput and/or otherwise facilitate assessment of a sample using charged particles.

According to an aspect of the invention, there is provided a method of assessing a sample surface using a charged particle beam directed towards the sample surface, the method comprising: at a first region of a sample surface on which is an intended pattern, relative scanning a beam over an elongate row portion of the intended pattern along a first direction; generating a row data set by detecting signal charged particles emitted from the sample surface during the relative scanning of the beam over the row portion; at a second region of the sample surface on which is a repeat of the intended pattern, relative scanning the beam over an elongate column portion of the intended pattern along a second direction, the first and second directions being angled relative to each other; generating a column data set by detecting signal charged particles emitted from the sample surface during the relative scanning of the beam over the column portion; and processing the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.

According to an aspect of the invention, there is provided a computer-implemented method of assessing a sample surface, comprising: receiving a row data set generated from, at a first region of a sample surface on which is an intended pattern, relative scanning a beam of charged particles over an elongate row portion of the intended pattern along a first direction; receiving a column data set generated from, at a second region of the sample surface on which is a repeat of the intended pattern, relative scanning the beam over an elongate column portion of the intended pattern along a second direction, the first and second directions being angled relative to each other; processing the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.

According to an aspect of the invention, there is provided an apparatus for assessing a sample surface, the apparatus comprising: a charged particle-optical device configured to direct a charged particle beam towards the sample surface of a sample, the charged particle-optical device being actuatable to electromagnetically scan the beam over the sample surface; a sample support configured to support the sample, the sample support being actuatable to provide relative movement between the sample support and the charged-particle-optical device; a controller; a detector; and a data processing device, wherein: the controller is configured to control the charged particle-optical device and the sample support to: at a first region of the sample surface on which is an intended pattern, perform relative scanning of the beam over an elongate row portion of the intended pattern along a first direction, and at a second region of the sample surface on which is a repeat of the intended pattern, relative scanning the beam over an elongate column portion of the intended pattern along a second direction, the first and second directions being angled relative to each other; the detector is configured to: generate a row data set by detecting signal charged particles emitted from the sample surface during the relative scanning of the beam over the row portion, and generate a column data set by detecting signal charged particles emitted from the sample surface during the relative scanning of the beam over the column portion; and the data processing device is configured to: process the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.

According to an aspect of the invention, there is provided a method of scanning a sample surface using a charged particle beam directed towards the sample surface, the method comprising: at a first region of a sample surface, relative scanning a beam over a plurality of row portions; and at a second region of the sample surface, relative scanning the beam over a plurality of column portions, wherein: the row portions are aligned perpendicularly or obliquely relative to the column portions.

According to an aspect of the invention, there is provided a charged particle assessment apparatus for assessing a sample by directing a plurality of charged particle beams towards the sample surface, the charged particle apparatus comprising: a sample support configured to support a sample; a charged particle device configured to direct a plurality of primary beams of charged particles arranged in a beam grid towards a region of a sample surface of the sample; and a controller configured to control relative motion between the plurality of beams and the sample surface so as to scan the beams over the region and to move the relative position between the sample surface and the beam grid so that the primary beams of the beam grid scan different regions, wherein the controller is configured to control the sample support to move in different directions across the beam grid when the primary beams of the beam grid scan a different region.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam assessment system.
**FIG. 2** is a schematic diagram illustrating an exemplary multi-beam charged particle assessment apparatus that is part of the exemplary charged particle beam inspection system of **FIG. 1****.**
**FIG. 3** is a schematic diagram of an exemplary electron optical device comprising a condenser lens array.
**FIG. 4** is a schematic diagram of an exemplary electron optical device comprising a macro collimator and macro scan deflector.
**FIG. 5** is a schematic diagram of an exemplary electron optical device comprising a beam separator.
**FIG. 6** is a schematic cross-sectional view of an objective lens array of a charged particle assessment system according to an embodiment.
**FIG. 7** is a bottom view of a modification of the objective lens array of **FIG. 7****.**
**FIG. 8** is a schematic diagram of a data path comprising a data processing device according to an embodiment.
**FIG. 9** is a schematic top view of a sample showing example locations of different regions (e.g., different dies).
**FIG. 10** is a magnified view of one of the regions of **FIG. 9** showing an example footprint of a charged particle-optical device.
**FIG. 11** is a magnified view of the example footprint of **FIG. 10** showing an example beam processable region corresponding to a single beam of a beam grid corresponding to the footprint.
**FIG. 12** depicts a row portion of an intended pattern in a first region on a sample, the row portion being in a beam processable region associated with a single beam of a beam grid.
**FIG. 13** depicts a row portion of a repeat of the intended pattern of **FIG. 12** in a second region on the sample, the row portion being in a beam processable region corresponding to that of **FIG. 12** and associated with the same beam of the beam grid.
**FIG. 14** depicts comparison of row images corresponding to the row portions of **FIG. 12** and **13** from different regions.
**FIG. 15** depicts identification of candidate defects from the comparison of **FIG. 14****.**
**FIG. 16** depicts how misalignment between row images from different regions can reduce an area of the intended pattern that can be compared using the row images.
**FIG. 17** depicts how overscanning of the row portions can increase the sizes of the row images and the area of the intended pattern that can be compared using the row images.
**FIG. 18** is a flow chart depicting a framework for a method of assessing a sample surface.
**FIG. 19** depicts a row portion of an intended pattern in a first region on a sample, the row portion being in a beam processable region associated with a single beam of a beam grid.
**FIG. 20** depicts a column portion of a repeat of the intended pattern of **FIG. 20** in a second region on the sample, the column portion being in a beam processable region corresponding to that of **FIG. 19** and associated with the same beam of the beam grid.
**FIG. 21-23** depict aligning of common portions of an intended pattern in a row portion and a column portion.
**FIG. 24** depicts scanning over multiple row portions spanning an assessment region.
**FIG. 25** depicts scanning over multiple column portions spanning the assessment region of **FIG. 26****.**
**FIG. 26** depicts an array of common portions corresponding to the row portions and column portions of **FIG. 24** and **25****,** each common portion corresponding to an intersection between a different combination of row portion and column portion.
**FIG. 27** and **28** shows how the scanning strategy of **FIG. 24** and **25** allows a smaller overscan to be applied to each row portion and column portion.
**FIG. 29** to **36** depict steps in processing of a plurality of sub-regions of an assessment region in sequence.
**FIG. 37** depicts mechanical and electrical scan directions for processing of an example beam processable region.
**FIG. 38** depicts an example hexagonal geometry of beams in a beam grid.
**FIG. 39** depicts beam processable regions corresponding to the beams depicted in **FIG. 38****.**
**FIG. 40** is a diagram illustrating a step and scan sequence.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution. For example, in an IC chip of a smart phone, which may be the size of a thumbnail and include over 2 billion transistors, the size of each transistor may need to be less than 1/1000th of a human hair. To achieve the increased resolution, semiconductor IC manufacturing has become a complex and time-consuming process, with hundreds of individual steps. Errors in even one of the steps may affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally considered to be references to charged particles, with the charged particles not necessarily being electrons.

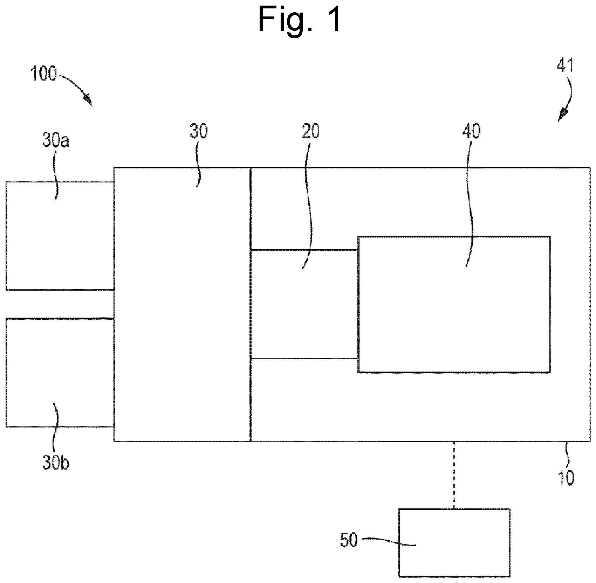

Reference is now made to **FIG. 1****,** which is a schematic diagram illustrating an exemplary charged particle beam inspection system 100, which may also be referred to as a charged particle beam assessment system or simply assessment system. The charged particle beam inspection system100 of **FIG. 1** includes a main chamber 10, a load lock chamber 20, an electron beam system 40, an equipment front end module (EFEM) 30 and a controller 50. The electron beam system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam system 40 may comprise a multi-beam electron-optical apparatus.

The controller 50 is electronically connected to electron beam system 40. The controller 50 may be a processor (such as a computer) configured to control the charged particle beam inspection apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam system, it should be noted that aspects of the disclosure in their broadest sense are not limited to a chamber housing an electron beam system. Rather, it is appreciated that the foregoing principles may also be applied to other devices, and other arrangements of apparatus, that operate under the second pressure.

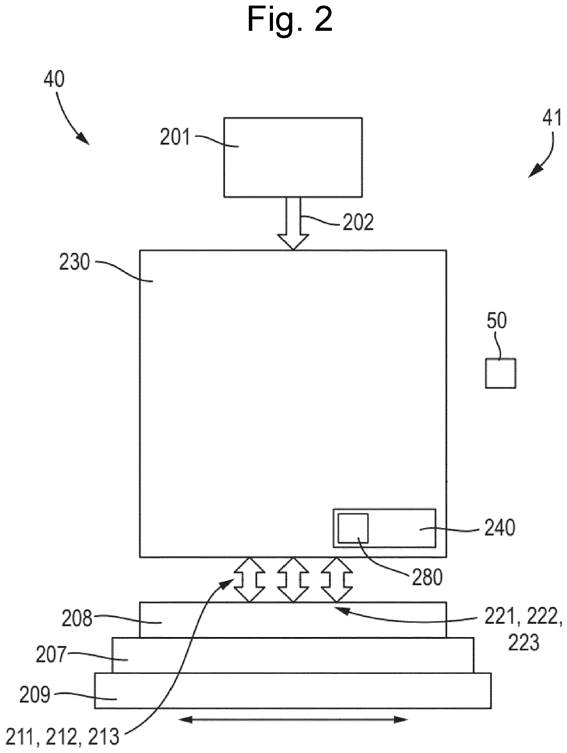

Reference is now made to **FIG. 2****,** which is a schematic diagram illustrating an exemplary electron beam system 40, including a multi-beam electron-optical system 41, that is part of the exemplary charged particle beam inspection system 100 of **FIG. 1****.** The electron beam system 40 comprises an electron source 201 and a projection apparatus 230. The electron beam system 40 further comprises a motorized stage 209 and a sample holder 207. The electron source 201 and projection apparatus 230 may together be referred to as the electron-optical system 41 or as an electron-optical column (or electron-optical device). The sample holder 207 is supported by motorized stage 209 so as to hold a sample 208 (e.g., a substrate or a mask) for inspection. The multibeam electron-optical system 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands, many tens of thousands or many hundreds of thousands of sub-beams. The sub-beams may be referred to as beamlets.

The controller 50 may be connected to various parts of the charged particle beam inspection apparatus 100 of **FIG. 1****,** such as the electron source 201, the detector 240, the projection apparatus 230, and the motorized stage 209. The controller 50 may perform various image and signal processing functions. The controller 50 may also generate various control signals to govern operations of the charged particle beam inspection apparatus, including the charged particle multibeam apparatus.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the electron beam system 40 such as the detector 240 (as shown in **FIG. 2**). However, the signal processing system 280 may be incorporated into any number of components of the inspection apparatus 100 or electron beam system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data such as in the form of one more data sets comprised in the signal, for example as a data stream, and may construct corresponding images from respective data sets, such as in the form of respective data-streams. The image acquirer may thus acquire images of the sample 208, for example in the form of data sets such as in data streams. The image acquirer may also perform various postprocessing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original, partially processed or processed data sets, and/or as original, at least partially processed images, and/or post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images (or other representations of the data sets) of the sample structures under inspection. Reference hereinafter to an image is intended also to refer to a data set unless stated to the contrary. The reconstructed images can be used to reveal various features of the internal or external structures of the sample 208. The reconstructed images can thereby be used to reveal any defects that may exist in the sample. The above functions of the signal processing system 280 may be carried out in the controller 50 or shared between the signal processing systems 280 and controller 50 as convenient.

The controller 50 may control the motorized stage 209 to move sample 208 during inspection of the sample 208. The controller 50 may enable the motorized stage 209 to move the sample 208 in one or more selected directions, continuously or discontinuously. In some arrangements, the movement may be performed at a constant speed. The movement of the sample 208 may be referred to as scanning or at least a mechanical scanning component of the scanning (which is referred hereinafter as mechanical scanning). It is noted that scanning may comprises electrostatic and/or magnetic scanning components, which are hereinafter referred to as electromagnetic scanning. The mechanical scanning may therefore be continuous or discontinuous. The controller 50 may control movement of the motorized stage 209 so that it changes the speed of the movement of the sample 208 dependent on various parameters. For example, the controller 50 may control the stage speed (and/or direction) depending on the characteristics of the inspection steps of scanning process and/or scans of the scanning process for example as disclosed in EPA 21171877.0 filed 3 May 2021 which is hereby incorporated in so far as the combined stepping and scanning strategy at least of the stage.

Known multi-beam systems, such as the electron beam system 40 and charged particle beam inspection apparatus 100 described above, are disclosed in US2020118784, US20200203116, US 2019/0259570 and US2019/0259564 which are hereby incorporated by reference.

The electron beam system 40 may comprise a projection assembly to regulate accumulated charges on the sample by illuminating the sample 208.

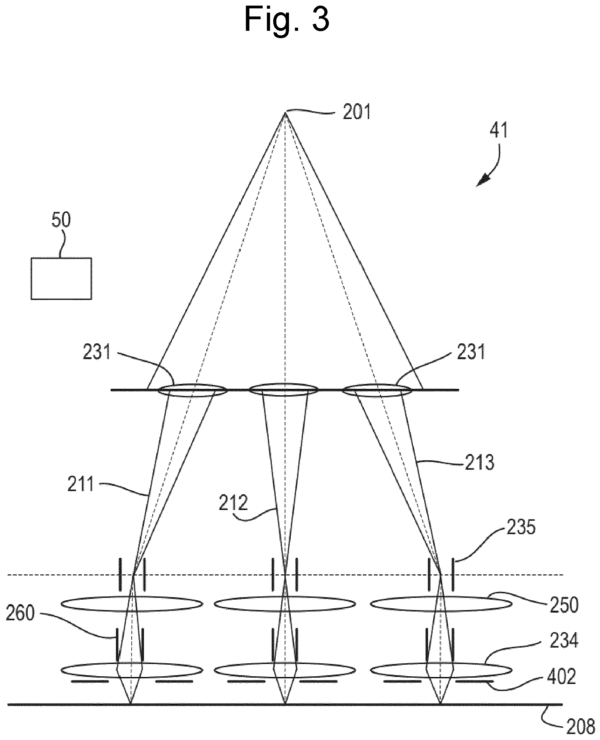

**FIG. 3** is a schematic diagram of an exemplary electron-optical device 41 (or electron-optical column) for use in an assessment system. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle arrangements such as those discussed herein, it will be understood however that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along sub-beam paths of sub-beams of a multi-beam.

The electron source 201 directs electrons toward an array of condenser lenses 231 (otherwise referred to as a condenser lens array). The electron source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, preferably three, acting as electrodes, with an aperture in each plate aligned with each other and corresponding to the location of a sub-beam. At least two of the plates are maintained during operation at different potentials to achieve the desired lensing effect. Between the plates of the condenser lens array are electrically insulating plates for example made of an insulating material such as ceramic or glass, with one or more apertures for the sub-beams. An alternative arrangement one more of the plates may feature apertures each with their own electrode, each with an array of electrodes around their perimeter or arranged in groups of apertures having a common electrode.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective sub-beam 211, 212, 213 which is focused at a respective intermediate focus 233. A collimator or an array of collimators may be positioned to operate on the respective intermediate focus 233. The collimators may take the form of deflectors 235 provided at the intermediate focuses 233. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample).

Below (i.e. downbeam of or further from source 201) deflectors 235 there is a control lens array 250 comprising a control lens 251 for each sub-beam 211, 212, 213. Control lens array 250 may comprise two or more, preferably at least three, plate electrode arrays connected to respective potential sources, preferably with insulating plates in contact with the electrodes for example between the electrodes. Each of the plate electrode arrays may be referred to as a control electrode. A function of control lens array 250 is to optimize the beam opening angle with respect to the demagnification of the beam and/or to control the beam energy delivered to the objective lenses 234, each of which directs a respective sub-beam 211, 212, 213 onto the sample 208.

Optionally an array of scan deflectors 260 is provided between the control lens array 250 and the array of objective lenses 234 (objective lens array). The array of scan deflectors 260 comprises a scan deflector 261 for each sub-beam 211, 212, 213. Each scan deflector is configured to deflect a respective sub-beam 211, 212, 213 in one or two directions so as to scan the sub beam across the sample 208 in one or two directions.

A detector module 240 of a detector is provided within or between the objective lenses 234 and the sample 208 to detect signal electrons/ particles emitted from the sample 208. An exemplary construction of such a detector module 240 is described below. Note that the detector additionally or alternative may have detector elements up-beam along the primary beam path of the objective lens array or even the control lens array.

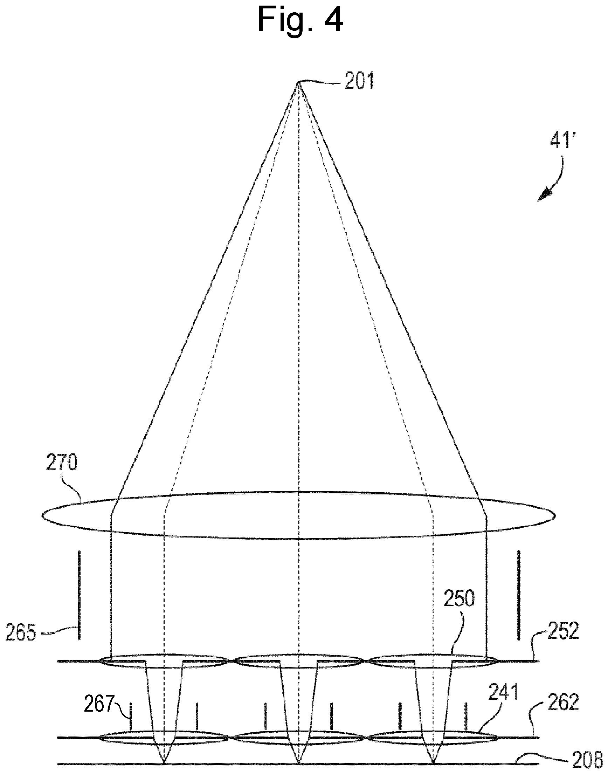

**FIG. 4** is a schematic diagram of an exemplary electron beam system having an alternative electron-optical device 41'. The electron-optical device 41' comprises an objective lens array 241. The objective lens array 241 comprises a plurality of objective lenses. The objective lens array 241 may be an exchangeable module. For conciseness, features of the electron beam system that have already been described above may not be repeated here.

As shown in **FIG. 4****,** the electron-optical device 41' comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The beam may separate into the sub-beams on meeting the control lens array 250. The sub-beams are substantially parallel on entry to the control lens array 250. The sub-beams of the multi-beam may be arranged in a pattern which may be referred to as a multi-beam arrangement. The pattern may form a grid. The grid may be hexagonal, rectilinear, rhombic or square. The multibeam may be referred to as a beam grid of primary beams for example directed towards the sample 208. In the example shown, a collimator is provided up-beam of the objective lens array assembly.

The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 comprise a magnetic lens and/or an electrostatic lens. In another arrangement (not shown), the macro-collimator may be partially or wholly replaced by a collimator element array provided down-beam of the upper beam limiter.

In the electron-optical device 41' of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 265 comprises a macroscopic multi-pole deflector, for example with eight poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250. In another arrangement (not shown), the macro scan deflector 265 may be partially or wholly replaced by a scan deflector array, for example as a scan deflector 267 for each sub-beam. In other embodiments both a macro scan deflector 265 and the scan-deflector array are provided, and they may operate in synchronization.

In some embodiments, the electron-optical system 41 further comprises an upper beam limiter 252. The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

In some embodiments, as exemplified in **FIG. 4****,** the objective lens array assembly (which is a unit that comprises the objective lens array 241) further comprises a beam shaping limiter 262. The beam shaping limiter 262 defines an array of beam-limiting apertures. The beam shaping limiter 262 may be referred to as a lower beam limiter, lower beam-limiting aperture array or final beam-limiting aperture array. The beam shaping limiter 262 may comprise a plate (which may be a plate-like body) having a plurality of apertures. The beam shaping limiter 262 may be down-beam from at least one electrode (optionally from all electrodes) of the control lens array 250. In some embodiments, the beam shaping limiter 262 is down-beam from at least one electrode (optionally from all electrodes) of the objective lens array 241. In an arrangement, the beam shaping limiter 262 is structurally integrated with an electrode of the objective lens array 241. Desirably, the beam shaping limiter 262 is positioned in a region of low electrostatic field strength. The alignment of the beam liming apertures with the objective lens array is such that a portion of a sub-beam from the corresponding objective lens can pass through the beam-limiting aperture and impinge onto the sample 208, so that only a selected portion of the sub-beam incident onto the beam shaping limiter 262 to pass through the beam-limiting aperture.

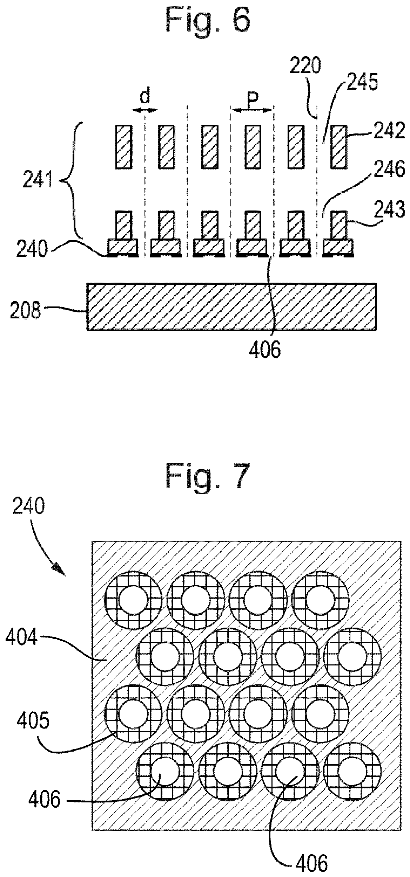

Any of the objective lens array assemblies described herein may further comprise a detector 240. The detector detects electrons emitted from the sample 208. The detected electrons may include any of the electrons detected by an SEM, including signal particles such as secondary and/or backscattered electrons emitted from the sample 208. An exemplary construction of a detector 240 is described in more detail below with reference to **FIG. 6** and **7**.

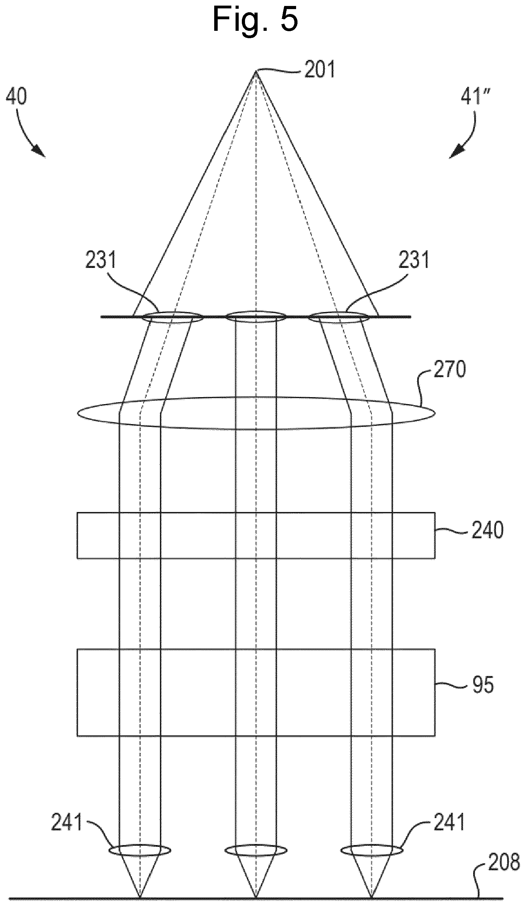

**FIG. 5** schematically depicts an electron beam system 40 including an electron-optical device 41" according to an embodiment. Features that are the same as those described above are given the same reference numerals. For conciseness, such features are not described in detail with reference to **FIG. 5****.** For example, the source 201, the condenser lenses 231, the macro collimator 270, the objective lens array 241 and the sample 208 may be as described above.

As described above, in an embodiment the detector 240 is between the objective lens array 241 and the sample 208. The detector 240 may face the sample 208. Alternatively, as shown in **FIG. 5****,** in an embodiment the objective lens array 241, which comprises the plurality of objective lenses, is between the detector 240 and the sample 208.

In an embodiment a separator array 95 is between the detector 240 and the objective lens array 241. The separator array 95 may comprise a deflector array for scanning the beams of the beam grid over the surface of the sample 208. Such a scanning deflector may scan the sub-beams relative to the sample surface during assessment of the sample 208. The deflector array 95 may function as a scanning deflector. In an embodiment the separator array 95 comprises a Wien filter array so the separator array may be referred to as a beam separator (or a beam separator array). The separator array 95 may comprise a component configured to provide a magnetic field, such as a magnetic deflector array. To function as a beam separator array, the separator array 95 may comprise an electrostatic scan deflector array and the magnetic deflector array. The electrostatic scan deflector array and the magnetic deflector array may be located at different positions along the path of the beam grid. The electrostatic scan deflector array and the magnetic deflector array may be configured to disentangle the charged particles projected to the sample 208 (for example as primary beams of the beam grid) apart from the secondary electrons from the sample 208 towards the detector 240. For example the primary beams in the beam grid may be deflected by the electrostatic scan deflector array and the magnetic scan deflector array differently so that the deflections of each of the deflector arrays cancel, whereas the signal particles are deflected by the two different scan deflector arrays so that the net deflection of the signal particles is a cumulation of the different deflections of the magnetic scan deflector array and the electrostatic scan deflector array.

In an embodiment the detector 240 is configured to detect signal particles by reference to the energy of the charged particle, i.e. dependent on a band gap. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be a scintillator array for example of fluorescing strip between the beams and that are positioned up beam along the primary beam path with respect to the Wien filter. Primary beams passing through the Wien filter array (of magnetic and electrostatic strips orthogonal to the primary beam path) have paths up beam and down beam of the Wien filter array that are substantially parallel, whereas signal electrons from the sample are directed by the Wien filter array towards the scintillator array. The generated photons are directed via a photon transport unit (e.g. an array of optical fibers) to a remote optical detector which generates a detection signal on detection of a photon

The objective lens array 241 of any embodiment may comprise at least two electrodes in which are defined aperture arrays. In other words, the objective lens array comprises at least two electrodes with a plurality of holes or apertures. **FIG. 6** shows electrodes 242, 243 which are part of an exemplary objective lens array 241 having respective aperture arrays 245, 246. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the sub-beam paths 220. Thus, the electrodes are each provided with apertures through which the respective sub-beam 211, 212, 213 propagates.

The objective lens array 241 may comprise two electrodes, as shown in **FIG. 6****,** or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens is that the energy of an incoming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than an objective lens of the objective lens array.

Preferably, each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the charged particle beam by a factor greater than 10, desirably in the range of 50 to 100 or more.

A detector 240 is provided to detect signal particles, i.e. secondary and/or backscattered charged particles, emitted from the sample 208. The detector 240 is positioned between the objective lenses 234 and the sample 208. On direction of a signal particle the detector generates a detection signal. The detector 240 may otherwise be referred to as a detector array or a sensor array, and the terms "detector" and "sensor" are used interchangeably throughout the application.

An electron-optical device for the electron-optical system 41 may be provided. The electron-optical device is configured to project a beam of electrons towards the sample 208. The electron-optical device may comprise the objective lens array 241. The electron-optical device may comprise the detector 240. The array of objective lenses (i.e. the objective lens array 241) may correspond with the array of detectors (i.e. the detector 240) and/or any of the beams (i.e. the sub-beams).

An exemplary detector 240 is described below. However, any reference to the detector 240 could be a single detector (i.e. at least one detector) or multiple detectors as appropriate. The detector 240 may comprise detector elements 405 (e.g. sensor elements such as capture electrodes). The detector 240 may comprise any appropriate type of detector. For example, capture electrodes for example to detect directly electron charge, scintillators or PIN elements can be used. The detector 240 may be a direct current detector or an indirect current detector. The detector 240 may be a detector as described below in relation to **FIG. 7****.**

The detector 240 may be positioned between the objective lens array 241 and the sample 208. The detector 240 is configured to be proximate the sample 208. The detector 240 may be very close to the sample 208. Alternatively, there may be a larger gap from the detector 240 to the sample 208. The detector 240 may be positioned in the device so as to face the sample 208. Alternatively, the detector 240 may be positioned elsewhere in the electron-optical system 41 such that part of the electron-optical device that is not a detector faces the sample 208.

**FIG. 7** is a bottom view of the detector 240 which comprises a substrate 404 on which are provided a plurality of detector elements 405 each surrounding a beam aperture 406. The beam apertures 406 may be formed by etching through the substrate 404. In the arrangement shown in **FIG. 7****,** the beam apertures 406 are in a hexagonal close packed array. The beam apertures 406 can also be differently arranged, e.g. in a rectangular, or a rhombic, array. The beam arrangement of the hexagonal arrangement in **FIG. 7** may be more densely packed than a square beam arrangement. The detector elements 405 may be arranged in a rectangular array or a hexagonal array. The beam apertures may correspond to the multi-beam arrangement of the sub-beams towards the substrate 404.

Capture electrodes 405 form the bottommost, i.e. most close to the sample, surface of the detector module 240. Between the capture electrodes 405 and the main body of the silicon substrate 404 a logic layer is provided. Logic layer may include amplifiers, e.g. Trans Impedance Amplifiers, analogue to digital converters, and readout logic. In an embodiment, there is one amplifier and one analogue to digital converter per capture electrode 405. A circuit featuring these elements may be comprised in a unit area referred to as a cell that is associated with an aperture. The detector module 240 may have several cells each associated with an aperture. Within or on the substrate is a wiring layer connected to the logic layer and externally connecting the logic layer of each cell for example via power, control and data lines. The integrated detector module 240 described above is particularly advantageous when used with a system having tunable landing energy as secondary electron capture can be optimized for a range of landing energies. A detector module in the form of an array can also be integrated into other electrode arrays, not only the lowest electrode array. Such a detector module may feature detectors that are scintillators or semiconductor detectors such as PIN detectors, for example above the down-beam most surface of the objective lens. Such detector modules may feature a similar circuit architecture as a detector module comprising a current detector. Further details and alternative arrangements of a detector module integrated into an objective lens can be found in WO2021140035A1 and WO2022008462A1, which documents are hereby incorporated by reference at least so far as details of the detector module.

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. More specifically, the detector 405 comprising multiple portions may be arranged around a single aperture 406, which provides an examples of such a detector. As mentioned the detection signal from the detector module is used to generate an image. With multiple detecting portions, the detection signal comprises components from the different detecting signals that may be processed as data sets or in a detection image.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the system and can be swapped between operable and non-operable positions without opening the electron beam system.

In some embodiments, one or more aberration correctors are provided that reduce one or more aberrations in the sub-beams. Aberration correctors positioned in, or directly adjacent to, the intermediate foci (or intermediate image plane) may comprise deflectors to correct for the source 201 appearing to be at different positions for different beams. Correctors can be used to correct macroscopic aberrations resulting from the source that prevent a good alignment between each sub-beam and a corresponding objective lens. Aberration correctors may correct aberrations that prevent a proper electron-optical alignment, for example of the different beams within the beam grid and of the beam grid with components along the path of the beam grid such as the sample. Aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. Aberration correctors may reduce one or more of the following: field curvature; focus error; and astigmatism.

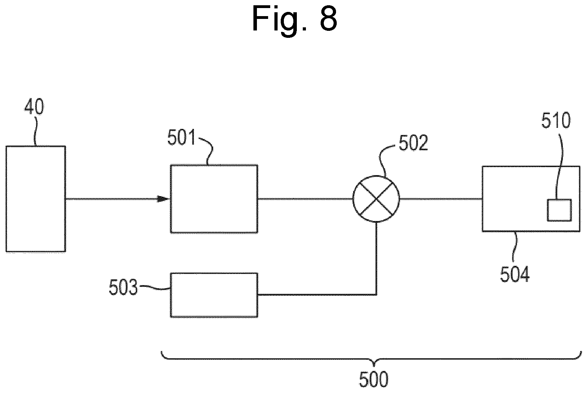

Images (which may be represented by image data sets) output from a charged particle assessment system, e.g. electron beam system 40, may be processed automatically to detect defects in samples 208 being assessed. An image data set (which may be referred to as an image) may comprise data points. The data points may be referred to as pixels. A region of pixels is an image which may be referred to as a clip. The region of pixels may surround a pixel or group of pixels identified as a potential defect. An example data processing device 500 for detecting defects in images generated by a charged particle assessment system is depicted in **FIG. 8****.** Data processing device 500 may be part of controller 50, part of another computer in the fab or integrated elsewhere in the charged particle assessment device. It should be noted that the arrangement of components of the data processing device 500 as shown and described with reference to **FIG. 8** is exemplary and is provided to aid explanation of the functions of data processors that operate on the images generated by the charged particle assessment system. Any feasible arrangement conceivable by a person skilled in the art of data processors that is able to achieve the functions of the data processing device 500 as described herein may be used.

In some embodiments, the data processing device 500 comprises a filter module 501 which receives and filters a sample image from a charged particle assessment system 40, a reference image generator 503 which generates a reference image based on source images, a comparator 502 which compares the filtered sample image to the reference image and an output module 504 which processes and outputs the result of the comparison. As described herein, the source image may be derived from another die of the sample, another region within the same die or an image generated from a library of images such as earlier scans or design information such as a GDS.

Filter module 501 applies a filter, e.g. a uniform filter, of predetermined size to the sample image. Applying a uniform filter comprises convoluting the sample image with a uniform kernel. The size of the uniform kernel is determined, e.g. by the user, for inspection of a given sample based on, for example, the size of features on the sample, the size of defects to be detected, the resolution of the charged particle assessment system, the amount of noise in the images and the desired compromise between sensitivity and selectivity. Deviation from a mathematically uniform filter is permissible. For example corner filters could have values that would slightly overweight those pixels but not significantly. Non-uniform filters, e.g. a Gaussian filter, may be conveniently implemented by convolution with a suitable kernel. Filter module 501, especially when configured to apply a uniform filter of predetermined size, is conveniently implemented by dedicated hardware, e.g. an FPGA or an ASIC.

The reference image generator 503 may be operable in one or more modes, each mode representing a different approach to generation of the reference image.

In a library mode, the reference image generator 503 averages a large number of source images obtained from previous scans of patterns nominally the same as the pattern currently being assessed. Such images may have been generated earlier in the same batch of samples, or from samples in previous batches. The library images may be derived from test samples, production samples or design data. Before averaging, the images are desirably aligned with one another. Averaging the source images to generate the reference image has the effect of reducing noise. Averaging the source images in this way also averages away any defects that might be visible in the source images. In a variation, for identifying defects, the scanned image may be compared to a reference image derived from design data. Comparing a scanned data with design data for identifying defects may be referred to as a die to database mode.

In the case where the pattern being inspected is a repeating pattern, it is possible to generate the reference image by averaging a plurality of shifted versions of a source image. If either or both dimensions of the unit cell are not equal to an integer number of pixels, the shift amount can be rounded to the nearest pixel or a fractional pixel shift can be effected by interpolation, for example linear or cubic interpolation, such as bicubic interpolation, or any other known interpolation technique. Another possibility is to shift by a multiple of the pitch of the repeating pattern such that the multiple is an integer number of pixels. In effect, multiple instances of the unit cell are extracted from the source image and averaged. This approach may be referred to as an example of an array mode, more specifically of providing a reference image for an array mode.

In a form of die-to-die mode, different incidences of scanning the same region of different dies by the same charged particle device or column may be compared. Desirably the same beam (of the same column in the case of a multi-column system) is used to generate a sample image and two reference images. This has the advantage that column to column and beam to beam corrections (e.g., correction of the relative position of a beam relative to the ideal beam position for that beam or even for each beam) are not required and the routing of data can be simplified. Using the same beam avoids the calibration, e.g. assessment of the offset, gain and/or spot profile differences from beam to beam, for the different scans that are compared. Using the same beam means that although the beam may have an offset with respect to the ideal beam position, there is no positional offset to correct for when comparing data retrieved from the scans. However, the need for data buffering might be increased, for example in frequency, if not in quantity of data buffered before the start of the comparison of the data from different dies.

An alternative version of array mode using a single charged particle optical device (or column), e.g. of a single-column system, provides a sample image which is compared against a reference image derived from two shifted versions of itself as source images. A buffer may be used to provide the shifted images.

It should be noted that it is also possible to apply the uniform filter to the source images and/or the reference images, in particular where the reference image is derived from a small number of source images that are obtained concurrently with the source image.

With reference again to **FIG. 8****,** comparator 502 may be any logic circuit capable of comparing two values, for example an XOR gate or a subtractor. Comparator 502 is also suitable for implementation by dedicated hardware, e.g. an FPGA or an ASIC. Desirably, comparator 502 is implemented on the same dedicated hardware as filter module 501.

In some cases, the reference image generator 503 can also be implemented in dedicated hardware, especially where the reference image generator operates only in a mode where the reference image is generated from a small number of, e.g. two, source images. In that case it is desirable that the reference image generator is implemented in the same dedicated hardware as the comparator and/or filter module. The mathematical operations to average pixels of source images and compare to a pixel of a sample image can, in suitable cases, be combined into a single logic circuit.

Output module 504 receives the results output by comparator 502 and prepares output to the user or other fab systems. The output may be in any of several different forms. In a simplest option, the output may simply be an indication that the sample has or does not have a defect. However, since almost all samples will have at least one potential defect more detailed information is desirable. The output may comprise, for example, a map of defect locations, a difference image, and/or information as to the severity of a possible defect represented by the magnitude of the difference between the sample image and the reference image. Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information as a data set may be used, e.g. a list or a map. Desirably, output module 504 may output clips. A clip is an image of a portion of the sample surface, or a region of pixels representative of potential defects. This allows the potential defect to be further examined to determine if clip is representative of a defect. That is that the defect is not actually a nuisance signal. Processing of the clip may determine if the defect is sufficiently significant to affect operation of the device structure which either is or could be formed on or present in the sample. The rest of the source image, i.e. those parts not saved as clips, may be discarded so as to avoid to conserve data storage and data transfer requirements.

As mentioned in the introductory part of the description, inspection processes that involve comparisons of patterns in different regions of a sample may require overscanning to ensure adequate coverage of the sample in the presence of inaccuracies in the scanning process. Overscanning is undesirable because it reduces throughput. Embodiments of the present disclosure described below allow inspection processes to be performed with less overscan, thereby improving throughput.

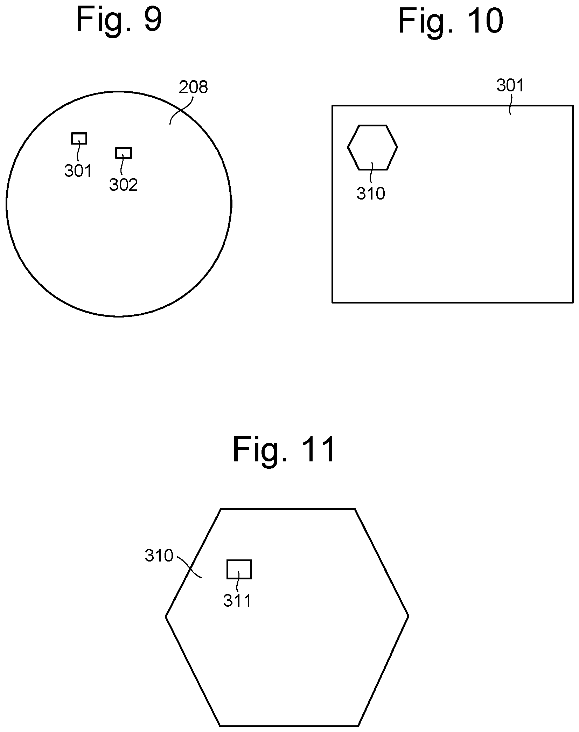

FIG. 9 to 11 depict an example scenario in which embodiments of the present disclosure may be applicable.

**FIG. 9** is a schematic top view of a sample 208 showing example locations of two different regions 301 and 302. The two regions 301 may comprise two different dies. In a different arrangement the two regions 301 may comprise different groups of dies (for example when the dies have a smaller dimension than different regions of a sample surface covered by the beam grid) or be within the same die.

The sample 208 may comprise a silicon wafer for example. **FIG. 10** is a magnified view of one of the regions 301 in **FIG. 9. FIG. 10** shows an example of a footprint 310 of a charged particle-optical device configured to direct a plurality of beams (which may be referred to as primary beams) of charged particles in a beam grid towards a region of a sample surface of the sample 208. The beam grid may be referred to as a multi-beam, as a plurality of sub-beams, or as a plurality of beams. The footprint 310 represents a region on the sample 208 that can be processed by the beam grid using movements of the beam grid relative to the sample 208 that do not go substantially beyond a pitch of the beam grid away from a starting position. (The footprint may be considered to be the area of a sample surface corresponding to a field of view of the beam grid at the sample surface). The pitch of the beam grid represents a size of a separation between nearest neighbor beams in the beam grid at the sample surface.

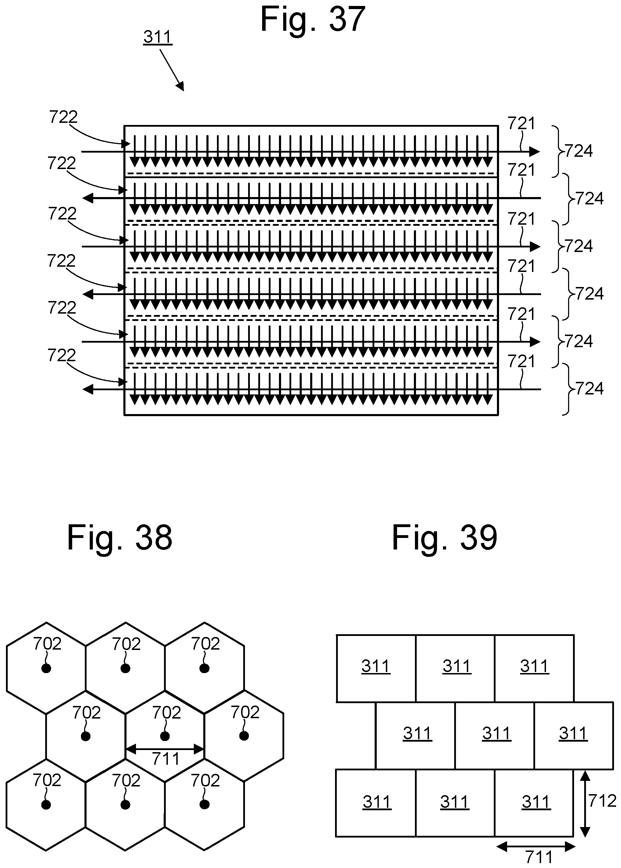

**FIG. 11** depicts an example beam processable region 311 of the footprint 310 that is allocated to an individual beam of the beam grid. As described later herein, a processable region 311 may be referred to as a beam area. The beam processable region 311 may have a range of shapes and sizes. In one example implementation, the beam processable region 311 is a rectangle having a longest side of less than about 100 microns. (As described later herein, the arrangement of beams in a beam grid which are each assigned such as shape of beam processing region, may be arranged in the beam grid with a different shape). Each beam of the beam grid may be allocated a different respective beam processable region 311 in the footprint 310 such that substantially all of the sample 208 in the footprint 310 can be processed using the movements of the beam grid relative to the sample 208 that do not go substantially beyond the pitch of the beam grid away from the starting position. An area of each beam processable region 311 may, for example, be substantially equal to an area of a unit cell of the beam grid where the beam grid intersects with the sample surface (for example the field of view of the beam grid over the sample surface. Further details about how beams of such a beam grid may be scanning over a sample 208 are discussed further below, particularly with reference to **FIG. 37** to **40****.**

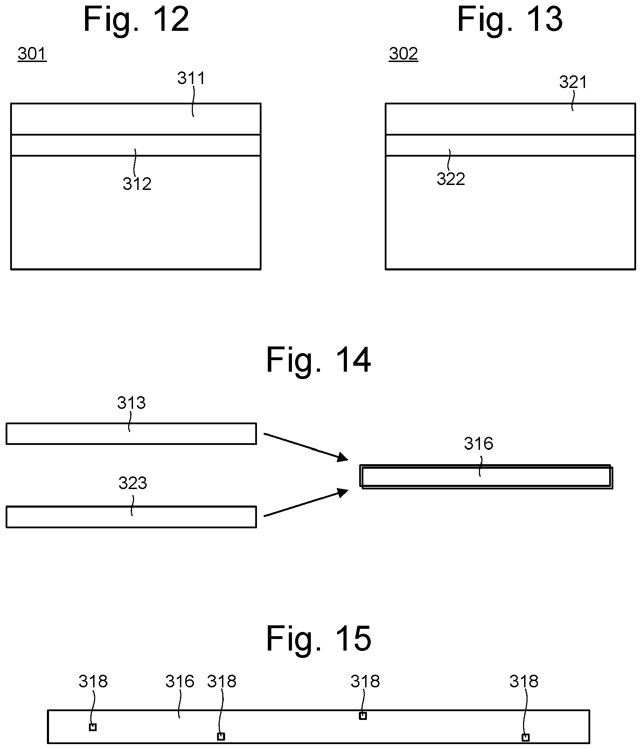

In the example scenario of **FIG. 9** to **11****,** the inspection processes mentioned above may compare portions of a pattern in the first region 301 with corresponding portions of the same pattern in the second region 302. In the case where the two regions are different parts of the same die, the patterns of the die within the regions may be similar (e.g., as described earlier with reference to the array mode). When the two regions cover multiple dies, the pattern comprised within the regions should be the same (so different dies in the region need not be the same, but dies in similar positions within different regions should be similar). In the case where the sample 208 is scanned by a beam grid, each comparison will typically be between portions that are scanned by the same beam of the beam grid. As depicted in **FIG. 12** to **14****,** for example, the comparison may comprise comparing row images from different beam processable regions 311, 312 of different regions 301, 302 which may be referred to, for the sake of convenience of labelling but not indicative of order or preference, as a first region 301 and a second region 302. The different beam processable regions may be substantially identical except for the location of the beam processing regions being in different regions 301, 302. For example as shown in **FIG. 14** a row image 313 (for first row image) may correspond to an image of a row portion 312 in the beam processable region 311 in the first region 301, for example as shown in **FIG. 12****.** As shown in **FIG. 14****,** a row image 323 (or a second row image) may correspond to a row portion 322 in the beam processable region 321 in the second region 302 as shown in **FIG. 13****.** The same beam may be assigned to the respective beam processing regions 311, 321 of the first region 301 and the second region 302 that is scanned. The position of the respective beam processing regions respectively withing the first region 301 and the second region 302 may be the same. Thus the same first row image 312 and the second row image 322 may be compared to each other.

**FIG. 14** schematically depicts the comparison process for the row images 313 and 323 (for example as the first row image and the second row image). The comparison involves an alignment process in which the row images 313 and 323 are computationally aligned (316) to obtain a best match between the row images 313, 323 (e.g., between corresponding patterns within each of the row images 313, 323). In the ideal case where portions of a pattern in the row images are defect free, the row images 313 and 323 may match exactly or sufficiently closely that no defects are detected. Alternatively, if defects 318 are present, as depicted schematically in **FIG. 15****,** the comparison may identify the locations of the defects 318. The locations of the defects 318 may be identified for example by finding pixels or groups of neighboring pixels where there is a significant mismatch between the data sets representing row images 313 and 323. Comparison of pixels or groups of pixels is provided as an example. It is also possible to refer to data sets or streams or other aspects of the data in order to locate defects. The locations of defects may for example be defined as coordinates (e.g., wafer or die level coordinates) representing defect location. A patch image (e.g., 50x50 pixels) of each potential defect location may be stored for a subsequent processing step (e.g., to determine whether the defect is a real defect and, if so, to classify the defect).

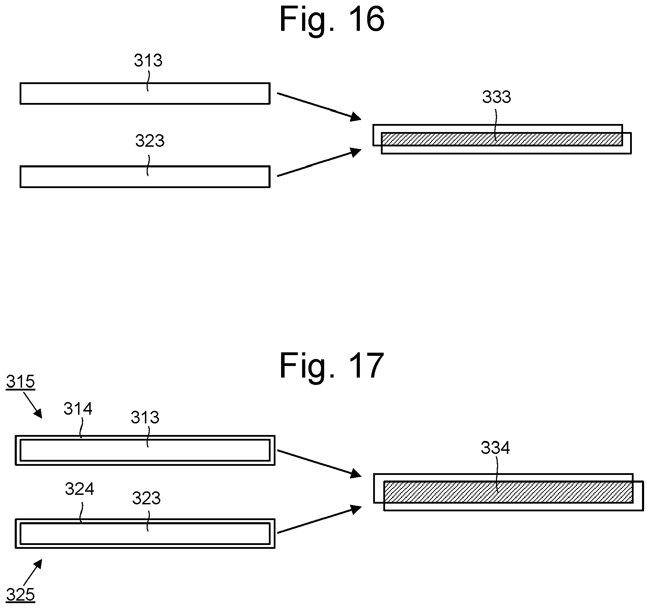

A challenge with the inspection process described above with reference to **FIG. 12-15** is that in practice there will be a positional offset between the row portion 312 and the row portion 322. The positional offset may comprise either or both of a static offset and a dynamic offset (e.g., a drift). Without a positional offset, an overlap region between the compared images, such as an overlap region 333 between the two row images 313, 323, is complete A consequence of the positional offset is that on alignment of the two row images 313, 323, portions (mismatch portions) of the two row images 313, 323 do not overlap. In an example as depicted schematically in **FIG. 16****,** the overlap region 333 is smaller than each of the row images individually. The portions (or mismatch portions) of the two row images 313, 323 that do not overlap may even be larger than the portion of the respective row images that represent the overlap region 333. Thus only a part, for example not all, of the portion of the pattern in either of the row images 313 and 323 can therefore be compared.

A solution to this may be to stitch together row images obtained from neighboring row portions (e.g., row portions above and below each of the row portions 312 and 322 shown in **FIG. 12** and **13**) but such image stitching is computationally costly and can produce errors. Image stitching may also be complex to implement and/or require large data sets and/or require up sampling to reducing stitching errors, which is computationally expensive.

Another solution is to overscan each of the row portions, as depicted in **FIG. 17****.** Overscanning involves scanning an area that is larger than a region of interest to ensure coverage of the region of interest. Referring to **FIG. 17****,** overscanned row image 315 is obtained by overscanning the row portion 312 in **FIG. 12****.** Overscanned row image 325 is obtained by overscanning the row portion 322 in **FIG. 13****.** Overscanned row image 315 may be seen as comprising the row image 313 and an overscan border 314 that extends beyond the row image 313. Overscanned row image 325 may be seen as comprising the row image 323 and an overscan border 324 extending beyond the row image 323. By configuring the overscanned row images 315 and 325 to be sufficiently large, it is possible to ensure that when the overscanned row images 315 and 325 are aligned the overlap region 334 is sufficiently large to cover the corresponding row portions 312 and 322. Such overscanning can ensure full coverage of a pattern to be assessed even where positional offsets are present. Thus even the mismatch regions of the two row images 313, 323 (should overscanning not be used) may be compared. In situations in which the overlapping region 333 (should overscan not be used) is most if not substantially all of one desirably both of each of the two row images 313, 323, overscanning may be a viable option. However, where the overlapping region is a smaller portion of the area of the row images 313, 315, such as shown in, and described with respect to the example of, **FIG. 17** overscanning may undesirably increase the scanning time and reduce throughput. Scanning of the same region multiple times may also lead to undesirable charging of the region, which may introduce errors and/or to resist shrinkage in the case of after development inspection (ADI). For example a total amount of overscan required is relatively large because it is necessary to overscan each row portion by a significant amount in all directions around the row portion. The required overscan borders 314 and 324 may thus need to be of approximately equal width around all of the perimeters of the row images 315, 325. The overscan may have a particularly heavy impact on throughput where the aspect ratio of the row images is relatively large, for example 1: 10 (e.g., 1:50) or larger and/or when the size of the position offset is an observable proportion of a shorter dimension of the image shape (e.g., row image shape), for example ten percent. In embodiments of the present disclosure described below, the required overscan is reduced by changing the scanning strategy. Throughput is thereby improved.

According to an embodiment, a method of assessing a sample surface of a sample 208 is provided that uses a charged particle beam directed towards the sample surface. The method may be implemented by an apparatus for assessing the sample surface.

The apparatus may be referred to as a charged particle assessment apparatus or an assessment apparatus, such as an inspection apparatus. In an embodiment, the apparatus comprises a charged particle-optical device configured to direct the beam towards the sample surface. The charged particle-optical device may be referred to as a charged particle-optical column. The charged particle-optical device may comprise or consist of the electron-optical device 41 described above with reference to **FIG. 3****,** the electron-optical device 41' described above with reference to **FIG. 4****,** or the electron-optical device 41" described above with reference to **FIG. 5****.** In an embodiment, the assessment apparatus comprises a sample support. The sample support is configured to support the sample 208. The sample support may comprise, or consist of, a stage 209. The stage 209 may take any of the forms described above with reference to **FIG. 1-7****.** The stage 209 may for example support the sample 208 via a sample holder 207. The sample support may be configured to provide relative movement between the sample support (and thereby sample 208) and a charged particle-optical device. The sample support may comprise a motorized stage 209 for example.

The charged particle-optical device may be actuatable to electromagnetically (for example electrostatically or magnetically) scan the beam over the sample surface. In such electromagnetic scanning, electric and/or magnetic fields may be varied in size and/or direction as function of time to scan the beam over the sample surface, for example in combination with movement of the stage, for example actuation of the stage. This scanning of the sample surface and the beams of the beam grid relative to each other may be achieved by the electromagnetic scanning of the beams (which is understood to comprise electrostatic scanning, magnetic scanning or a combination of electrostatic scanning and magnetic scanning) by a deflector and mechanical scanning of the sample for example by the stage. The electromagnetic scanning may be implemented for example as electrostatic scanning by the scan deflectors 260 in the electron-optical device 41 of **FIG. 3****,** by the electrostatic scanning by scan deflectors 267 and/or magnetic or electrostatic scanning by the deflector 265 in the electron-optical device 41' of **FIG. 4****,** or by the electromagnetic scan deflectors within the separator array 95 in the electron-optical device 41" of **FIG. 5** (when the separator array 95 is configured to function as a scanning deflector). The scan deflectors may be positioned relatively close to the sample 208, or be in a configuration such that a leverage point of the beams is close to the sample 208. In such implementations, the leverage (or length of beam path) over which the scan deflectors operate may as a consequence be relatively small relative to the scale of the sample 208. Other designs of scan deflectors are known where the scan deflectors are at a greater distance from the sample and therefore have greater leverage. Such scanning (whether by magnetic and/or electrostatic scan deflectors) may be referred to as electromagnetic scanning, electrical scanning, electric scanning or electronic scanning.

In an embodiment, the assessment apparatus comprises a controller 50. The controller 50 may take any of the forms described above with reference to **FIG. 1** and **2** or other forms. The controller 50 may be configured to control at least the sample support and the charged particle-optical device (e.g., column) to perform the method. The controller 50 may take the form of distributed subcontrollers. For example, the controller 50 may comprise any suitable combination of data-processing hardware, firmware, software and/or computer-controlled actuators, sensors, etc. necessary for providing the desired functionality.

In an embodiment, the apparatus comprises a detector 240. The detector 240 is configured to detect signal charged particles emitted from the sample surface in response to impingement of the beam on the sample surface. The detector 240 may take any of the forms described above, for example with reference to **FIG. 6** and **7****.** Such a detector may for example feature in electron-optical devices 41, 41' as shown in and described with reference to **FIG. 2** to **4****.** The detector 240 may for example comprise one or more detector elements 405. The detector 240 may comprise a detector array. The detector array may comprise a detector element. The detector elements may transmit a detection signal on detection of a signal particle.

In an embodiment, the apparatus comprises a data processing device 500. The data processing device 500 may take any of the forms described above with reference to **FIG. 8** or other forms. The data processing device may be distributed. The data processing device may comprise part of the controller 50, so far as such controller may for example be configured to process data.

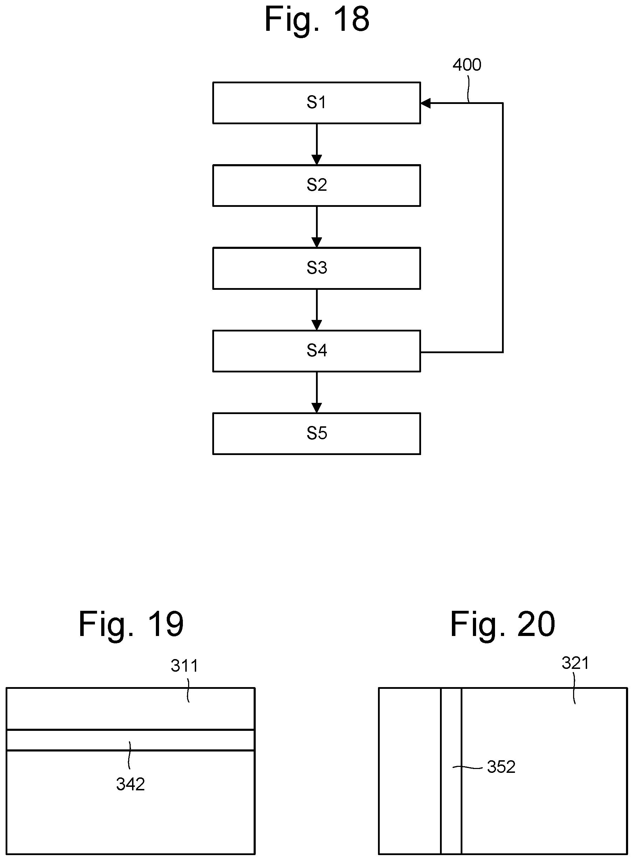

The method comprises the steps depicted in **FIG. 18****.** The steps may be implemented by the controller 50 controlling the charged particle-optical device, the sample support, the detector 240 and/or the data processing device 500. It should be noted the order of the elements of the method are not necessarily required to occur in the order described in the numbered steps described herein. The order of the elements as such may be in any reasonably feasible order.

A method may comprise obtaining scanning a first region 301 for example in a first step, Step S1. The scanning is performed at a first region 301 of the sample surface. An intended pattern is on the first region 301 of the sample surface. The intended pattern may be substantially equal in size or smaller than the first region 301. The first region 301 may comprise at least part of a first die. The first region 301 may be the first die. As exemplified in **FIG. 19** the scanning, for example in step S 1 comprises, at the first region 301, relative scanning a beam over an elongate row portion 342 of the intended pattern along a first direction. The first direction may correspond to a direction of elongation of the row portion 342. The direction of elongation may be referred to as a long axis. In the example shown in **FIG. 19****,** the first direction is horizontal in the plane of the page.

In an embodiment, the relative scanning of the beam over the row portion 342 of the intended pattern comprises mechanical scanning. The mechanical scanning comprises providing relative movement between the sample surface and a charged particle-optical device directing the beam towards the sample surface. The relative movement may be parallel to the first direction. The mechanical scanning may be implemented at least partly by actuating a sample support supporting the sample 208 to move the sample 208 parallel to the first direction.

In an embodiment, the relative scanning of the beam over the row portion 342 further comprises electromagnetic scanning (e.g., scanning using either or both of an electric field and a magnetic field) of the beam. The electromagnetic scanning may comprise electromagnetic scanning substantially perpendicularly to the first direction, substantially parallel to the first direction, and/or substantially at a direction angled with respect to the first direction such as at 45 degrees. The electromagnetic scanning may comprise electromagnetic scanning in any direction relative to the first direction.

The method, for example in a second step, Step S2, comprises generating a row data set. The row data set is generated by detecting signal charged particles emitted from the sample 208 during (and in response to) the relative scanning of the beam over the row portion 342. The generation of the row data, for example in Step S2, may be performed by the detector 240, for example by detecting signal charged particles emitted from the sample surface in response to impingement of the beam on the sample surface. In an embodiment, the row data set may be processed to generate a row image 343 (e.g., by a rendering process). The row image 343 is an image of the row portion 342 of the intended pattern. The combination of the mechanical scanning and the electromagnetic scanning may be configured to provide sufficient coverage of the row portion 342 by the scanning to provide the row image 343.

The method, for example in a third step, Step S3, comprises performing scanning at a second region 302 of the sample surface. A repeat of the intended pattern is on the second region 302 of the sample surface. The second region 302 may comprise at least part of a second die. The second region 302 may be the second die. Alternatively the second region 302 may comprise at least part of, or be, a region overlapping between the first die and the second die. The second region 302 may alternatively be in the same die as the first region 301. At least a portion of the first region 301 and at least a portion of the second region 302 may be in the same die. The first region 301 and the second region 302 may be separated from each other, as depicted in **FIG. 9****.** Alternatively, the first region 301 and the second region 302 may be substantially adjoining. Typically the first region 301 will be nonoverlapping with the second region 302. As exemplified in **FIG. 20****,** the scanning at the second region 302, for example in Step S3, comprises relative scanning a beam over an elongate column portion 352 of the intended pattern along a second direction. The second direction may correspond to a direction of elongation of the column portion 352. The direction of elongation may be referred to as a long axis. In the example shown in **FIG. 20****,** the second direction is vertical in the plane of the page.

In an embodiment, the relative scanning of the beam over the column portion 352 of the intended pattern comprises mechanical scanning. The mechanical scanning comprises providing relative movement between the sample surface and the charged particle-optical device. The relative movement may be parallel to the second direction. The mechanical scanning may be implemented at least partly by actuating the sample support to move the sample 208 parallel to the second direction.

In an embodiment, the relative scanning of the beam over the column portion 352 further comprises electromagnetic scanning of the beam. The electromagnetic scanning may comprise electromagnetic scanning substantially perpendicularly to the second direction, substantially parallel to the second direction, and/or substantially at a direction angled relative to the second direction, for example at 45 degrees. The electromagnetic scanning may thus comprise electromagnetic scanning in any direction relative to the first direction.

Typically, the mechanical scanning is slower than the electromagnetic scanning. Typically, the electromagnetic scanning has a smaller range than the mechanical scanning. The smaller range of the electromagnetic scanning may determine the width of the elongate row and column portions. For beams in a beam grid, an aspect ratio of each row portion and column portion may be determined by the range of the electromagnetic scanning and the beam pitch in the beam grid.

The first direction and the second direction are angled relative to each other. The first direction is therefore not parallel with the second direction. In an embodiment, as exemplified in **FIG. 19** and **20****,** the first direction is perpendicular to the second direction. Alternatively, the first direction may be oblique relative to the second direction (i.e., neither perpendicular nor parallel thereto).

The method, for example in a fourth step, Step S4, comprises generating a column data set. The column data set is generated by detecting signal charged particles emitted from the sample surface during the relative scanning of the beam over the column portion 352. Generating the column data set, for example in Step S4, may be performed by the detector 240, for example by detecting signal charged particles emitted from the sample surface in response to impingement of the beam on the sample surface. In an embodiment, the column data set is processed to generate a column image 353 (e.g., by a rendering process). The column image 353 is an image of the column portion 352 of the intended pattern.

The method, for example in a fifth step, Step S5, comprises processing the row data set and the column data set. The processing of the row data set and the column data set may comprise comparing a common portion of the intended pattern present in both the row data set and the column data set. The comparing may comprise comparing between the row data set and the column data set, for example between the respective common portions of the row data set and the column data set. Such processing of the row data set and the column data set, such as at Step S5, may be performed by the data processing system 500. The common portion of the intended pattern is a portion of the intended pattern that is common to both the row portion of the intended pattern and the column portion of the intended pattern. The comparison is used to assess the common portion of either or both of the row portion and the column portion. For example, differences between the common portion of the row portion and the common portion of the column portion may be identified as candidate defects in either or both of the row portion and the column portion (i.e., candidate defects in a portion of the intended pattern corresponding to the common portions). The processing may thus comprise identifying candidate defects in the intended pattern in the first region 301 or second region 302.

Processing by the data processing system 500 may comprise a computer-implemented method. A computer-readable medium, optionally non-transitory, may be provided that comprises instructions which, when executed by a computer (e.g., the data processing system 500), cause the computer to carry out the method. The computer-implemented method may comprise receiving a row data set generated from, at a first region 301 of a sample surface on which is an intended pattern, relative scanning a beam over an elongate row portion 342 of the intended pattern along a first direction. The method may further comprise receiving a column data set generated from, at a second region 302 of the sample surface on which is a repeat of the intended pattern, relative scanning the beam over an elongate column portion 352 of the intended pattern along a second direction. The first and second directions are angled relative to each other. The method may further comprise processing the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.

In an embodiment, the relative scanning of the beam over the row portion 342 of the intended pattern and the relative scanning of the beam over the column portion 352 of the intended pattern comprise electromagnetic scanning of the beam in a common direction (e.g., in the same direction or in a similar direction). Alternatively or additionally, the electromagnetic scanning is configured such that an average direction of the electromagnetic scanning of the beam during the relative scanning of the beam over the row portion 342 is within a range of +/- 20 degrees of, optionally within a range of +/- 10 degrees of, optionally within a range of +/- 5 degrees of, optionally substantially parallel to, an average direction of the electromagnetic scanning of the beam during the relative scanning of the beam over the column portion 352. Arranging for the electromagnetic scanning to be in a common direction or near to a common direction in this manner improves a quality of the comparison of the common portion of the intended pattern in the row portion with the common portion of the intended pattern in the column portion because the data sets representative of each of the common portions will have been obtained in a more similar manner, for example the common portions will have been imaged in a more similar way. Ideally the common potions are scanned and the generated datasets are processed similarly if not identically.

Arranging for the electromagnetic scanning to be in the common direction or near to the common direction can be achieved in various ways. For example, in one embodiment, an average direction of the electromagnetic scanning is substantially parallel to the first direction during the relative scanning of the row portion 342 and during the relative scanning of the column portion. For the row portion 342, this may mean that an average direction of the electromagnetic scanning is substantially parallel to (or within +/- 20 degrees of) the direction of the mechanical scan. Full coverage of the row portion 342 may be achieved in this scenario by scanning the beam in the first direction or near to the first direction at multiple different positions across the width of the row portion and repeating the process at different positions along the first direction. If the width is covered before the mechanical scan has advanced in the first direction by more than a range of the electromagnetic scan then full coverage of the row portion 342 can be achieved. For the column portion 352, an average direction of the electromagnetic scanning may be substantially perpendicular to (or within +/- 20 degrees of being perpendicular to) the direction of the mechanical scan. An example of such relative scanning is depicted in **FIG. 37** and discussed in further detail below with reference to **FIG. 37****.** In another embodiment, which may be implemented in an analogous manner, an average direction of the electromagnetic scanning is substantially parallel to the second direction during the relative scanning of the row portion 342 and during the relative scanning of the column portion 352. In still another embodiment, an average direction of the electromagnetic scanning is at substantially 45 degrees to the first direction during the relative scanning of the row portion 342 and during the relative scanning of the column portion 352.

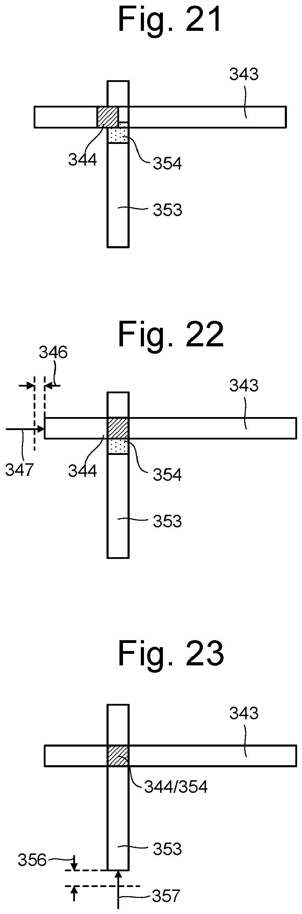

In an embodiment the processing of the row data set and the column data set, for example in Step S5, comprises aligning the common portion 344 of the intended pattern in the row data set with the common portion 354 of the intended pattern in the column data set. Such aligning may enable comparison of the common portions 344, 354. The figures as shown in **FIG. 21** to **23** depict an example aligning method.

In **FIG. 21** is depicted relative positioning of a row image 343 and a column image 353. The row image 343 is generated by processing the row data set before the aligning. The column image 353 is generated by processing the column data set before the aligning. The common portion 344 in the row image 343 is offset relative to the common portion 354 in both the first direction and the second direction.

As schematically depicted in **FIG. 22****,** the aligning of the common portions 344, 354 may comprise adjusting a position of the row image 343 relative to the column image 353 in a direction parallel to the first direction (as indicated by arrow 347). In the example of **FIG. 22****,** the row image 343 is moved by an offset distance 346, which in the page of **FIG. 22** is a movement to the right.

As schematically depicted in **FIG. 23****,** the aligning of the common portions 344, 354 may comprise adjusting a position of the column image 353 relative to the row image 343 in a direction parallel to the second direction (as indicated by arrow 357). In the example of **FIG. 23****,** the column image 353 is moved upwards by an offset distance 356.

Performing the adjusting of **FIG. 22** before the adjusting of **FIG. 23** is purely exemplary. In other embodiments, the adjusting of **FIG. 23** is performed before the adjusting of **FIG. 22** or at the same time as the adjusting of **FIG. 22****.**

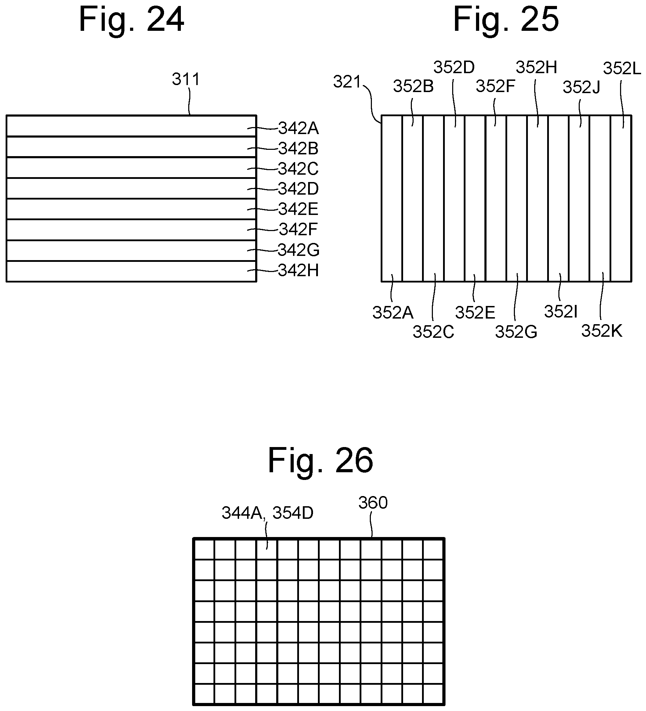

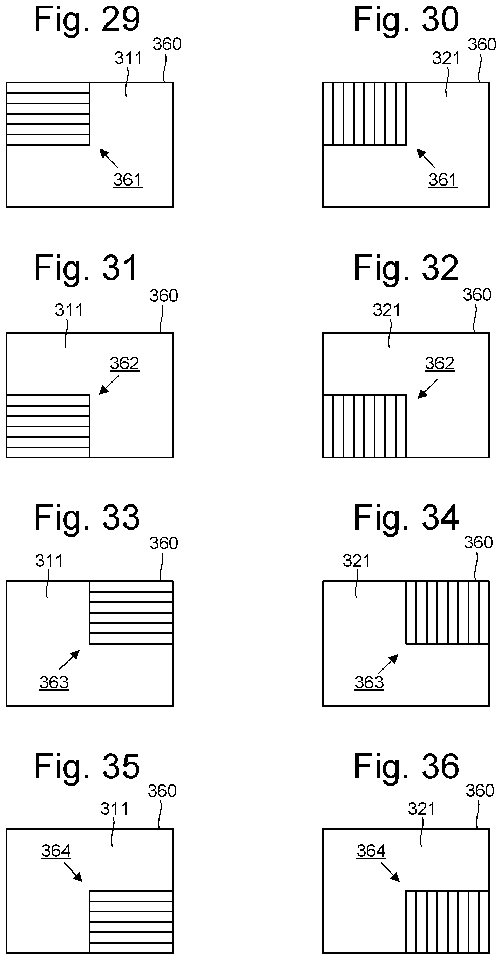

The aligning of the common portions 344 and 354 can be performed with a small or substantially no overscan of the row portion 342 in the second direction (perpendicular to the long axis of the row portion 342). Relative to the case where row images from two row portions 312 and 322 need to be compared, as in the arrangement discussed above with reference to **FIG. 12** to **17****,** the size of the overscan of the row portion 342 in the second direction is less. This is because any inaccuracy in the positioning of the row portion 342 in the direction perpendicular to the long axis of the row portion 342 can be compensated for in the aligning process by an adjustment in the position of the column image 353 along the second direction (e.g., as depicted in **FIG. 22**). Analogously, the aligning of the common portions 344 and 345 can also be performed with a relatively small or even substantially no overscan of the column portion 352 in the first direction (perpendicular to the long axis of the column portion 352). This is for the analogous reason that any inaccuracy in the positioning of the column portion 352 in the direction perpendicular to the long axis of the column portion 352 can be compensated for in the aligning process by an adjustment in the position of the row image along the first direction (e.g., as depicted in **FIG. 21**). If multiple row images and column images are used to assess an assessment region, in such a way that substantially all of each row image and column image contributes to the assessment, a substantial reduction in total overscan requirements is achieved. The reduction in total overscan requirements is substantial because of the reduction in overscan requirements perpendicular to the respective long axes of the row portions 342 and column portions 352 discussed above. The reduction in overscan is substantial in comparison to the case where the same assessment region is assessed by comparing row portions with row portions using an arrangement such as that discussed with reference to **FIG. 12** to **17****.** Example approaches are discussed below with reference to **FIG. 24** to **36****.** In such an arrangement, the assessment region 360 may correspond (e.g., be substantially equal in size and shape) to the beam processable region 311, 321 (as shown in **FIG. 24** and **25**) or be a fraction thereof (as shown in and as will be described later herein in reference to **FIG. 29** to **36**).

As illustrated in **FIG. 24** and indicated schematically by arrow 400 in **FIG. 18****,** in an embodiment the relative scanning at the first region 301 is repeated (e.g., by repeating the first step, step S1) for a plurality of different row portions 342A-H of the intended pattern in the first region 301. The repeated relative scanning for a plurality of the different row portions 342A-H generates a corresponding plurality of the row data sets (e.g., by repeating the second step, Step S2).

As illustrated in **FIG. 25****,** in an embodiment the relative scanning at the second region 302 is repeated (e.g., by repeating the third step, Step S3) for a plurality of different column portions 352A-L of the intended pattern in the second region 302. The repeated relative scanning for a plurality of the different column portions 352A-L generates a corresponding plurality of column data sets (e.g., by repeating Step S4).

The method illustrated with reference to **FIG. 24** and **25** is thus an example of a method of scanning a sample surface in which a beam is relatively scanned over a plurality of row portions 342, at a first region 301 of the sample surface. At a second region 302 of the sample surface, the beam is relative scanned over a plurality of column portions. The row portions 342 are aligned perpendicularly or obliquely relative to the column portions 352.

As illustrated in **FIG. 26****,** in an embodiment the method comprises assessing an assessment region 360 by assessing common portions corresponding to a plurality of pairs of row data set and column data set, for example a row data set is paired to a column data set for assessing one of the common portions. A row data set may have a common portion with each of the column data sets. A column data set may have a common portion with each of the row data sets. That is, a row data set is restricted to the paired column data set for the common portion corresponding to the paired row data set and column data set. The assessment region 360 may be a continuous assessment region formed by substantially adjoining common portions from different pairs. At least a subset of the common portions, optionally all of the common portions, may tessellate with each other over the assessment region to provide continuous (e.g. gapless) coverage of the assessment region. Adjoining common portions may be substantially contiguous. In the example of **FIG. 26****,** each small rectangle (which may be square or rectangular) within the assessment region 360 corresponds to a common portion of a different pair of row data set and column data set. Each different pair corresponds substantially to an intersection between a corresponding row image and column image after the row image and column image have been aligned as described above with reference to **FIG. 21** to **23****.** Thus, for example, the intersection between a row image e.g. 342A in **FIG. 24** and a column image, e.g. 352D **FIG. 25****,** may correspond to a common portion which is labelled in **FIG. 26****.** The intersection may correspond to the fourth common portion 354D from the left of the row image of the row portion 342A in **FIG. 26****.** The intersection may correspond to the top common portion 344A of a column image corresponding to column portion 352D.

In an embodiment, the relative scanning at the first region 301 is performed such that the plurality of row portions 342A-H cover substantially all of a region of the sample 208 corresponding to the assessment region 360 in the first region 301. Similarly, the relative scanning at the second region 302 is performed such that the plurality of column portions 352A-L cover substantially all of the region of the sample 208 corresponding to the assessment region 360 in the second region 302. By covering substantially all of the assessment region 360 with row portions at the first region 301 and with column portions at the second region 302, it is ensured that substantially all of the assessment region 360 can be assessed without any unnecessary scanning of the sample surface. (This is apart from a deliberate amount of overscan in directions parallel to the respective long axes of the row portions and column portions, as discussed below. Such overscan is desirably limited and is smaller than the extent of overscan that may be required in the arrangement shown and described with reference to **FIG. 17**).

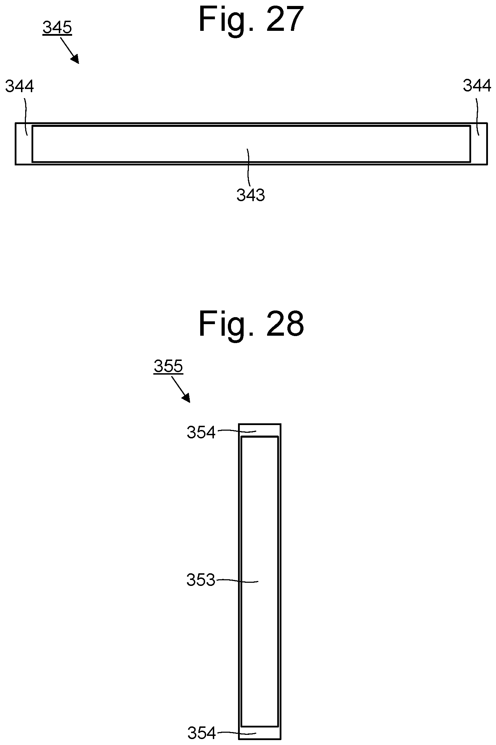

As discussed above with reference to **FIG. 21** to **23****,** the common portions in each pair (i.e. each pair of respective row portions and column portions) can be aligned without requiring substantial overscan. Such overscan is reduced in particular in directions perpendicular to the long axes of the respective row portion 342 and column portion 352. Each row portion 342 will, however, still need to be overscanned in directions parallel to the long axis of the row portion 342. Such an overscan may be a significant distance, for example by an amount similar to that required in the case described above with reference to **FIG. 17****.** An example of an overscanned row image 345 is depicted schematically in **FIG. 27****.** The overscanned row image 345 is obtained by overscanning the respective row portion 342. In a similar way to the arrangement of **FIG. 17****,** the overscanned row image 345 may be seen as comprising a row image 343 and an overscan border 344 extending beyond the row image 343. However, in contrast to the arrangement of **FIG. 17****,** the overscan border 344 in **FIG. 27** is only relatively thick at the longitudinal ends of the row image 343. The width of the row image 343 is typically much shorter (e.g., more than 10 times shorter, optionally more than 50 times shorter) than the length of the row image 343. This means that the total amount of overscanned area (the area associated with the overscan border 344) is much smaller in the case of **FIG. 27** than in the case of **FIG. 17****.** The difference may also be expressed in terms of the overscan as a proportion of the dimension of the elongate portion in the direction of the overscan. The proportion of the dimension of such overscan relative to the dimension of an elongate portion in the direction of elongation of the present invention such as shown in **FIG. 27** (such as a row portion in the direction of the row) may be small, if not relatively insignificant. This is compared to the overscan in the arrangement shown in and described with reference to **FIG. 17****;** in the arrangement of the prior art, the proportion of the dimension of such overscan relative to the dimension across an elongate portion is large if not significant. Therefore in an embodiment, the proportion of dimension of elongate portion in the direction of the overscan relative to the magnitude of the overscan (in the direction of overscan) may be reduced. Thus the amount of excess scanning to achieved the required overscan is reduced.

**FIG. 28** illustrates an example of an overscanned column image 355, where the total amount of overscanned area (the area associated with the overscan border 354 around the column image 353) is substantially the same as in the case of **FIG. 27** and therefore also much smaller than in the case of **FIG. 17****.** Similarly, **FIG. 28** relative to the arrangement shown in and described with reference to **FIG. 17** shows that in a direction of overscan, the dimension of the overscan as a proportion of the elongate portion in the direction of the overscan is reduced. Hence the scanning is more accurate and proportionally excess scanning to achieve the required overscan is reduced. Thus, the assessment region 360 can be assessed with higher throughput (less required overscan) by using the scanning strategy involving row portions in the first region 301 and column portions in second region 302 than an alternative approach using row portions in both the first region 301 and the second region 302.

In an embodiment, the assessing of the assessment region 360 is performed after all of the row data sets and column data sets of the assessment region 360 have been generated. In such a case, the row portions 342 and column portions 353 may be arranged to cover substantially all of the assessment region 360 as discussed above with reference to **FIG. 24** to **26** for example.

Alternatively, the assessing of the assessment region 360 may comprise processing a plurality of sub-regions of the assessment region 360 for example in sequence. The processing of each sub-region comprises generating row data sets and generating column data sets. The generated row data sets and the generated data sets correspond to the sub-region (e.g., spanning the sub-region but not extending beyond the sub-region). The processing of each sub-region may then comprise assessing common portions corresponding to the row data sets and column data sets of the sub-region. An example of this approach is described below with reference to **FIG. 29** to **36** for a case where the assessment region 360 corresponds to beam processable regions 311 and 321 for a single beam of a beam grid.

**FIG. 29** and **30** depict processing of a first sub-region 361 of the assessment region 360. The processing comprises generating row data sets in a portion of the beam processable region 311 in the first region 301 that corresponds to the first sub-region 361 of the assessment region 360 (a top left quadrant in the example shown). The processing comprises generating column data sets in a portion of the beam processable region 321 in the second region 302 that also corresponds to the first sub-region 361 of the assessment region 360 (the top left quadrant in the example shown). The corresponding row images and column images can then be aligned and compared as described above to assess the first sub-region 361 (e.g., to detect defects in the first sub-region 361).

**FIG. 31** and **32** depict corresponding processing of a second sub-region 362, which in the example shown is a bottom left quadrant. Row images and column images resulting from the processing can be aligned and compared to assess the second sub-region 362.

**FIG. 33** and **34** depict corresponding processing of a third sub-region 363, which in the example shown is a top right quadrant. Row images and column images resulting from the processing can be aligned and compared to assess the third sub-region 363.

**FIG. 35** and **36** depict corresponding processing of a fourth sub-region 364, which in the example shown is a bottom right quadrant. Row images and column images resulting from the processing can be aligned and compared to assess the fourth sub-region 364.

Thus, assessing of the assessment region 360 can be split into multiple individual stages. In the example of **FIG. 29** to **36** the assessing is split into four stages but it will be understood that the number of stages is arbitrary and could be fewer than four or more than four. Splitting the assessment of the assessment region 360 into multiple stages may reduce computational resource requirements of the data processing device 500, such as memory requirements, storage requirements, and/or bandwidth requirements. The processing of beam processable regions of the different regions 301, 302 may be restricted to one or more sub-regions of the beam processable regions, selected for example such that the statistical chance of detecting a defect is sufficient for an application or use case by scanning such a reduced area of the sample surface. Such a use case may be when defect detection data is required in a shorter amount of time than can be achieved by scanning all the sub-regions.

Alternatively or additionally, computational requirements may be reduced by using information obtained during alignment of one pair of row image and column image. The obtained information, such as the offset between the paired row image and column image, for example the offset in the direction of the row and the offset in the direction of the column, may be used to assist with aligning of another pair of row image and column image. The obtained information, may be used for aligning other pairs of row images and column images corresponding to the same beam or different beams in the beam grid. This approach is particularly applicable to embodiments in which relative scanning at the first region 301 and second region 302 is repeated for a plurality of row portions and a plurality of column portions, for example for assessing common portions covering the assessment region. The relative scanning of the plurality of row portions and the plurality of the column portions may lead to generation of of row data sets and column data sets. The row data sets and the column data sets may be paired into different pairs of row data sets and column data sets for different common portions (or a plurality of pairs of a row data set and a column data set). The different pairs of row data sets and column data sets may be assessed, for example as described above with reference to **FIG. 24** to **36****.**

In an embodiment, the method comprises assessing a common portion corresponding to a first pair of the plurality of pairs. The assessing comprises generating offset information defining how to align (or alignment of) the common portion of the intended pattern in the row data set of the first pair with the common portion of the intended pattern in the column data set of the first pair. The assessing comprises comparing the common portions of the first pair.

In an embodiment, the method comprises assessing a common portion of one or more second pairs of the plurality of pairs. The assessing comprises, for each second pair, using the generated offset information for the first pair to at least partially align the common portion of the intended pattern in the row data set of the second pair with the common portion of the intended pattern in the column data set of the second pair. The assessing comprises comparing the common portions of the second pair. In a different arrangement the offset information may be applied to the plurality of rows and the plurality of columns to obtain a plurality of aligned rows and a plurality of aligned columns. The common portions derived from the different beam processable regions at the different regions 301, 302 may be defined by superimposing the aligned rows and aligned columns. After alignment, for example by application of the offset information, the beam processable regions of the different regions may correspond. The assessing may comprise comparing the superimposed portions of the aligned rows and aligned columns, which correspond to the common portions.

Thus, the offset information obtained when aligning the common portions of the first pair is reused to assist with aligning the common portions of the second pair for example other common portions of the assessment region. Such aligning may feedforward the alignment information obtained from an alignment of another such as an earlier processed common portion. This may be possible because one of more factors contributing to the offset of the common portions in the first pair may contribute to an offset of the common portions of the second pair or other pair of the assessment region. This approach may desirably reduce computational requirements for aligning the other common portions such as of the second pair. This approach may reduce the computation load in calculating a respective offset for aligning each common pair, for example of the assessment region. For example, a search space (for example for alignment of a common portion) may be reduced or eliminated, for example by using offset information from aligning another common portion. The offset information for the earlier for example the first pair may be used to provide a coarse alignment, with a finer alignment being performed subsequently using only the row data set and the column data set of the respective later, for example the second pair (thereby reducing the search space) for example as well as all other common portions, for example of the assessment region. Alternatively, the offset information for the first pair may be used as the sole alignment information for aligning the common portions of the second pair (thereby eliminating the search space) for example as well as all other common portions, for example of the assessment region. The offset information may be reused for a single second pair or for multiple second pairs. In an embodiment, the offset information is reused for every pair of row data set and column data set corresponding to an assessment region 360 or a sub-region 361-364 of an assessment region 360 apart from the first pair. Although reference is made to just the assessment region related to a beam of the beam grid, the processing of the assessment regions related to other beams of the beam grid may be similar and simultaneous. Therefore to reduce the processing load, a selection of the beams of the beam grid such as one or more of the beams, for example every hundredth, fiftieth, tenth, fifth, third or second beam may be used to process a respective assessment region when the beam grid processes two regions 301, 302 of the sample surface. Offset information between rows and columns of an assessment region by scanning such a beam may be applied to one or more other beams and their respective processing regions. In an arrangement offset information may be fedforward to processing two regions at least one of which is different from the first and second regions 301, 302. In an arrangement one of the regions may be a region of a different sample.

In an embodiment, the generating offset information comprises determining a location of the common portion in a row image generated from the row data set of the first pair. Referring to the example of **FIG. 21** to **23****,** the location of the common portion 344 in the row image 343 may thus be determined. The location may be determined by calculating the offset (e.g., distance offset 346) that is required to adjust the row image 343 such that the common portion 344 is aligned with the column image 353 along the long axis of the column image 353. The generating offset information may thus comprise calculating an offset in at least one degree of freedom between the location of the common portion 344 in the row image 343 and the location of the common portion 354 in the column image 353. The at least one degree of freedom may comprise translation along the first direction, although other geometrical operations may be used, include translations along other directions and/or rotations. The generating offset information may comprise calculating a row offset representing a shift in a direction parallel to the first direction that aligns the location of the common portion 344 in the row image 343 with the column image 353 in a direction parallel to the second direction. The distance offset 346 is thus an example of a row offset.

In an embodiment, the generating offset information comprises determining a location of the common portion 354 in a column image 353 generated from the column data set of the first pair. Referring to the example of **FIG. 21** to **23****,** the location of the common portion 354 in the column image 353 may thus be determined. The location may be determined by calculating the offset (e.g., distance offset 356) that is required to adjust the column image 353 such that the common portion 354 is aligned with the row image 343 along the long axis of the row image 343. The at least one degree of freedom in the calculating of the offset may thus comprise translation along the second direction. The generating offset information comprises calculating a column offset representing a shift in a direction parallel to the second direction that aligns the location of the common portion 354 in the column image 353 with the row image 343 in a direction parallel to the first direction. The distance offset 356 is thus an example of a column offset.

Any of the methods described above with reference to **FIG. 18** may be performed for each of two or more, optionally all, beams of a beam grid. Thus, the method may comprise projecting a plurality of the beams onto the sample surface as a beam grid and assessing a plurality of assessment regions 360 using respective beams of the beam grid (e.g., with a one-to-one correspondence between beams and assessment regions 360). Each beam may process a different respective assessment region 360.

In an embodiment, the assessing of the plurality of assessment regions 360 is performed by relative scanning of respective beams of the beam grid over the assessment regions. The relative scanning may be performed by mechanical scanning and electromagnetic scanning (e.g., scanning using either or both of an electric field and a magnetic field). In the mechanical scanning the beam grid is scanned over the sample surface by relative movement between the sample surface and a charged particle-optical device. During the mechanical scanning, the charged particle-optical device projects the beam grid towards the sample surface. The electromagnetic scanning comprises electromagnetically scanning the beams of the beam grid over respective assessment regions 360.

As discussed above with reference to **FIG. 11****,** a beam processable region 311, 321 may be allocated to each beam of the beam grid. The beam processable region 311, 321 may be referred to as a beam area. Thus, the different primary beams are assigned different beam areas. The assessment region 360 may correspond (e.g., be substantially equal in size and shape) to the beam processable region 311, 321 (as shown in **FIG. 24** and **25**) or be a fraction thereof (as shown in **FIG. 29** to **36**). Thus, an area of a unit cell of the beam grid where the beam grid intersects with the sample surface may be substantially equal to an area of each assessment region 360 or substantially equal to an integer multiple of the area of each assessment region 360 (e.g., four, as in the example of **FIG. 29** to **36****,** or any other integer greater than one).

Thus, in an embodiment a charged particle device of a charged particle assessment apparatus may be configured to direct a plurality of beams (which may be referred to as primary beams) of charged particles arranged in a beam grid towards a region of a sample surface of the sample 208. The region may correspond to the field of view of the beam grid over the sample surface. The different primary beams of the beam grid may have a field of view over the sample surface that corresponds to a beam processable region 311 (or beam area). A controller 50 of the charged particle assessment apparatus may be configured to control relative motion between a plurality of beams of the beam grid and the sample surface so as to scan the beams over the region (e.g., the first region 301 mentioned above) and to move the relative position between the sample surface and the beam grid so that the beams of the beam grid scan different regions (e.g., the second region 302 and/or one or more other regions that is/are different from the first region 301). The controller 50 is configured to control the sample support to move in different directions across the beam grid when the primary beams of the beam grid scan a different region. For example, the controller 50 may move the sample support parallel to the first direction to scan over row portions 342, such as the row portions 342A-H shown in **FIG. 24****,** when the beam grid is scanning at the first region 301. A detection signal from a detector may represent corresponding row data sets, which may represent respective row images. The controller 50 may move the sample support parallel to the second direction to scan over column portions 353, such as the column portions 353A-L shown in **FIG. 25****,** when the beam grid is scanning at the second region 302. A detection signal from the detector may represent corresponding column data sets, which may represent respective column images. Different primary beams may be assigned different beam areas (or beam processable regions) within the region. In an embodiment, a detector array comprises a detector element for detecting signal particles emitted by the sample surface in response to the primary beams incident on the sample 208. The detector elements may transmit a detection signal on detection of a signal particle. In an embodiment, the relative motion at a first region of the different regions is in a first direction, desirably the detection signal representing a row data set, such as a row image. In an embodiment, the relative motion at a second region of the different regions is in a second direction. The detection signal may represents a column data set, such as a column image. The first and second directions are angled, preferably perpendicular, to each other. In an embodiment, the charged particle device is configured to perform electromagnetic scanning of the beams during the movement of the sample support in one or more fast scan directions. The one or more fast scan directions comprise substantially parallel to the movement of the sample support, substantially perpendicular to the movement of the sample support, and/or at substantially 45 degrees to the movement of the sample support. In an embodiment, the apparatus is configured to compare data sets represented by detector signals from detector elements generated from scanning at least part of the different regions.

Further details of an example scanning method for scanning a beam grid over the sample 208 are given below with reference to **FIG. 37** to **40****.** The scanning method may be used with any of the embodiments described above with reference to **FIG. 9** to **36****.**

A first step of the scanning method is exemplified in **FIG. 37** for a single example beam of a beam grid, for example for relative scanning of a beam processable region 311. The different beams of the beam grid may be scanned over a respective beam processable area within a region of the sample surface. For relative scanning of a beam of a beam grid over the beam processable region of the sample surface, a sample support is used to move the sample 208 in a direction parallel to a mechanical scan direction (e.g., along one of the horizonal paths 721 shown in **FIG. 37**). During this movement a charged particle-optical apparatus is used to repeatedly move the beam grid (e.g., by controlling scan deflectors) relative to the sample surface in a direction parallel to an electromagnetic (e.g., electrostatic or magnetic) scan direction, different from the mechanical scan direction (e.g., along the vertical paths 722 shown in **FIG. 37**). An elongate portion 724 is thus scanned, for example across the beam processable region 311. The elongate portion 724 may extend across the beam processable region 311 in such a way as to correspond to one of the row portions 342 or one of the column portions 352 discussed above, depending on the orientation of the sample 208 relative to the mechanical scan direction.

Each beam of the beam grid may scan a different respective elongate portion 724 at the same time. Each different respective elongate portion 724 may be in a different respective beam processable region 311. The beam grid can thus simultaneously scan a plurality of elongate portions 724 corresponding to the plurality of beams in the beam grid.

The paths 721 and 722 and the elongate portions 724 are depicted schematically in **FIG. 37** so as to be visible in the diagram. In practice the paths 721 and 722 will be more closely spaced and many more elongate portions 724 will be processed, for example twenty to one thousand. The widths of the elongate portions 724, which may be defined by an available range of electromagnetic (e.g., electrostatic and/or magnetic) deflection, may typically be in the range of 0.2-5.0 microns, for example 0.5-2.0 microns. The lengths of the regions 724, which may be defined by the pitch of the beams in the beam grid, may typically be in the range of 50-500 microns. Together the different elongate portions 724 of the surface of the sample scanned by a beam define the beam processable region 311.

The combination of the beam processable regions 311 may be referred to as a footprint of the charged particle-optical device, a field of view of the charged particle device, or a field of view of the beam grid. The field of view of the beam grid may be referred to as the unit cell of the beam grid where the beam grid intersects with the sample surface. To scan more of the sample surface than an area of the footprint requires the sample 208 to be moved far enough that the beams can scan respective beam processed regions 311 within a new footprint. The new footprint may adjoin the previous footprint, so that a continuous region can be scanned, or may be separated from the previous footprint.

**FIG. 38** and **39** depict an example relationship between a geometry of a beam grid (defined by grid positions 702 of the beams) and a geometry of beam processable regions 311. Each beam processable region 311 may be covered by an array of the elongate portions (e.g., row portions or column portions). The array will typically be rectangular or square. The array may have other forms, such as parallelogram or rhombus.

The example of **FIG. 38** and **39** demonstrates that the symmetry of the beam grid does not need to be the same as the symmetry of the beam processable regions 311. In the example shown, the beams are provided on a hexagonal grid (i.e., a grid having hexagonal symmetry), while the beam processable regions 311 are rectangular. Continuous coverage of the sample surface parallel to the mechanical scan direction (horizontally in the orientation depicted) may be achieved by arranging for the lengths of the elongate portions 724 to be substantially equal to the pitch 711 of the beam grid in the mechanical scan direction (i.e. the width of the tessellating hexagons centered on the grid positions 702). Continuous coverage of the sample surface parallel to the electromagnetic scan direction (vertically in the orientation depicted) may be achieved by arranging for the sum of the widths of the elongate portions 724 in each beam processable area (or beam processable region) to be substantially equal to a pitch 712 of the beam grid in the electromagnetic scan direction (neglecting any required overscanning).

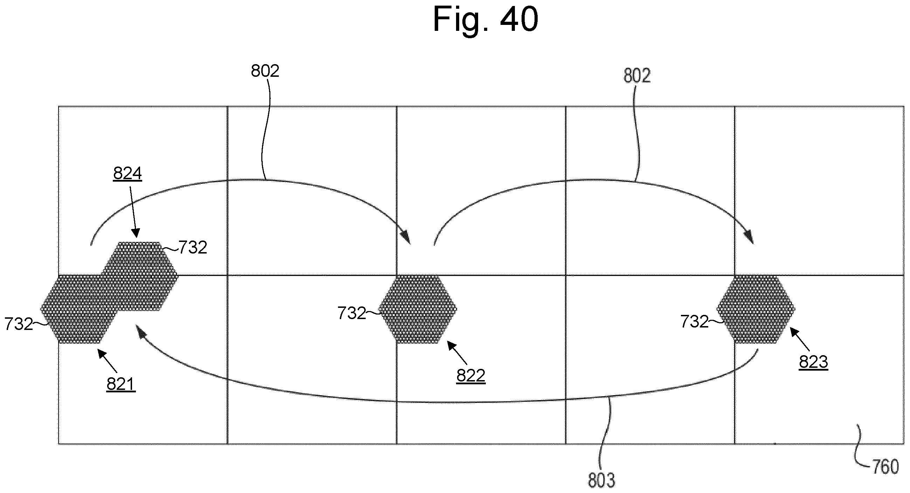

In some embodiments, each beam processes a beam processable region 311 at plural different processing regions on the sample surface. The first region 301 and second region 302 discussed above with reference to **FIG. 9** are examples of such different processing regions. The different processing regions may be different regions within the same die (for example array mode), regions in different dies (for example die to die mode) or encompass more than one die (the arrangement of the dies and their patterns within different processing regions being substantially similar). The different processing regions may correspond to different footprints of the surface of the sample 208 that may be spaced apart. In a different arrangement, the different processing regions may be of different samples 208, for example the same relative location over the same patterned features e.g. die on the different sample. **FIG. 40** depicts an example step and scan sequence in an example embodiment in which a rectilinear grid of pattern repeat regions 760 are present on the sample surface. In this case, the different processing regions may be in or overlap with different respective pattern repeat regions 760 or combinations of pattern repeat regions 760. The beams may thus process beam processable regions 311 with the charged particle-optical device predominantly facing one of the pattern repeat regions 760 and then move the sample 208 to a position where the charged particle-optical device is predominantly facing a different one of the pattern repeat regions 760. This may be referred to as a step and scan sequence. In the example shown, the beam processable regions 740 corresponding to each scanning phase are within a hexagonal footprint 732 (corresponding to an example geometry of the beam grid). The example step and scan sequence moves the footprint 732 in sequence from a starting footprint position 821 through footprint positions 822-823 via steps 802. A larger step 803 then brings the footprint 732 back either to a different starting footprint position 824 (as shown in **FIG. 40**), or to the same starting footprint position (not shown), and the sequence can be repeated.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments of electron optical device for example components of the electron-optical device 41, 41', 41" herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

An assessment tool, assessment system, or assessment apparatus according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems or apparatus are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array 250 and objective lens array 241, under the control of the controller or control system or control unit. An actuatable component, such as a stage, may be controllable to actuate and thus move relative to another components such as the beam path using one or more controllers, control systems, or control units to control the actuation of the component.

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The terms "sub-beam" and "beamlet" and "beam of a beam grid" etc. are used interchangeably herein and are understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

The term "image" used herein is intended to refer to any array of values wherein each value relates to a sample of a location and the arrangement of values in the array corresponds to a spatial arrangement of the sampled locations. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A method of assessing a sample surface using a charged particle beam directed towards the sample surface, the method comprising: at a first region of a sample surface on which is an intended pattern, relative scanning a beam over an elongate row portion of the intended pattern along a first direction; generating a row data set by detecting signal charged particles emitted from the sample surface during the relative scanning of the beam over the row portion; at a second region of the sample surface on which is a repeat of the intended pattern, relative scanning the beam over an elongate column portion of the intended pattern along a second direction, the first and second directions being angled relative to each other; generating a column data set by detecting signal charged particles emitted from the sample surface during the relative scanning of the beam over the column portion; and processing the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.
Clause 2. The method of clause 1, wherein the first region and the second region are adjoining or separated from each other.
Clause 3. The method of clause 1 or 2, wherein the first region is at least part of a first die and the second region is at least part of a second die, or at least a portion of the first region and at least a portion of the second region are in the same die.
Clause 4. The method of any preceding clause, wherein the first direction is perpendicular to the second direction.
Clause 5. The method of any preceding clause, wherein the first direction is oblique to the second direction.
Clause 6. The method of any preceding clause, wherein the processing the row data set and the column data set comprises aligning the common portion of the intended pattern in the row data set with the common portion of the intended pattern in the column data set to compare the common portions.
Clause 7. The method of clause 6, comprising: processing the row data set to generate a row image, the row image being an image of the row portion of the intended pattern; and processing the column data set to generate a column image, the column image being an image of the column portion of the intended pattern.
Clause 8. The method of clause 7, wherein the aligning of the common portions comprises adjusting a position of the row image relative to the column image in a direction parallel to the first direction.
Clause 9. The method of clause 7 or 8, wherein the aligning of the common portion comprises adjusting a position of the column image relative to the row image in a direction parallel to the second direction.
Clause 10. The method of any preceding clause, wherein: the relative scanning of the beam over the row portion of the intended pattern comprises mechanical scanning, the mechanical scanning comprising providing relative movement between the sample surface and a charged particle-optical device directing the beam towards the sample surface, parallel to the first direction, desirably at least partly by actuating a sample support supporting the sample to move the sample parallel to the first direction; and the relative scanning of the beam over the column portion of the intended pattern comprises mechanical scanning, the mechanical scanning comprising providing relative movement between the sample surface and the charged particle-optical device, parallel to the second direction, desirably at least partly by actuating the sample support to move the sample parallel to the second direction.
Clause 11. The method of clause 10, wherein: the relative scanning of the beam over the row portion of the intended pattern comprises electromagnetic scanning of the beam, the electromagnetic scanning optionally comprising electromagnetic scanning substantially perpendicularly to the first direction, substantially parallel to the first direction, and/or substantially at 45 degrees to the first direction; and the relative scanning of the beam over the column portion of the intended pattern comprises electromagnetic scanning of the beam, the electromagnetic scanning optionally comprising electromagnetic scanning substantially perpendicularly to the second direction, substantially parallel to the second direction, and/or substantially at 45 degrees to the second direction.
Clause 12. The method of clause 11, wherein the relative scanning of the beam over the row portion of the intended pattern and the relative scanning of the beam over the column portion of the intended pattern comprise electromagnetic scanning of the beam in a common direction and/or electromagnetic scanning such that an average direction of the electromagnetic scanning during the relative scanning of the beam over the row portion is within a range of +/- 20 degrees of an average direction of the electromagnetic scanning during the relative scanning of the beam over the column portion.
Clause 13. The method of any of clauses 10 to 12, wherein the mechanical scanning is slower than the electromagnetic scanning and/or the electromagnetic scanning has a smaller range than the mechanical scanning.
Clause 14. The method of any preceding clause, wherein: the relative scanning at the first region is repeated for a plurality of different row portions of the intended pattern in the first region to generate a corresponding plurality of the row data sets; the relative scanning at the second region is repeated for a plurality of different column portions of the intended pattern in the second region to generate a corresponding plurality of column data sets; and the method comprises assessing an assessment region by assessing common portions corresponding to a plurality of pairs of row data set and column data set.
Clause 15. The method of clause 14, wherein the assessment region is a continuous assessment region formed by substantially adjoining common portions from different pairs, optionally wherein at least a subset of the common portions tessellate with each other over the assessment region.
Clause 16. The method of clause 15, wherein the assessing the assessment region is performed after all of the row data sets and column data sets of the assessment region have been generated.
Clause 17. The method of clause 15, wherein the assessing the assessment region comprises processing a plurality of sub-regions of the assessment region in sequence, the processing of each sub-region comprising generating row data sets and column data sets corresponding to the sub-region and assessing common portions corresponding to the row data sets and column data sets of the sub-region.
Clause 18. The method of any of clauses 14 to 17, wherein assessing a common portion corresponding to a first pair of the plurality of pairs comprises generating offset information defining how to align the common portion of the intended pattern in the row data set of the first pair with the common portion of the intended pattern in the column data set of the first pair, to compare the common portions of the first pair.
Clause 19. The method of clause 18, wherein assessing the common portion of one or more second pairs of the plurality of pairs comprises, for each second pair, using the generated offset information for the first pair to align the common portion of the intended pattern in the row data set of the second pair with the common portion of the intended pattern in the column data set of the second pair, to compare the common portions of the second pair.
Clause 20. The method of clause 18 or 19, wherein the generating offset information comprises determining a location of the common portion in a row image generated from the row data set of the first pair.
Clause 21. The method of clause 20, wherein the generating offset information comprises determining a location of the common portion in a column image generated from the column data set of the first pair.
Clause 22. The method of clause 21, wherein the generating offset information comprises calculating an offset in at least one degree of freedom between the location of the common portion in the row image and the location of the common portion in the column image.
Clause 23. The method of clause 22, wherein the generating offset information comprises calculating a row offset representing a shift in a direction parallel to the first direction that aligns the location of the common portion in the row image with the column image, the alignment being with respect to a direction parallel to the second direction.
Clause 24. The method of clause 22 or 23, wherein the generating offset information comprises calculating a column offset representing a shift in a direction parallel to the second direction that aligns the location of the common portion in the column image with the row image, the alignment being with respect to a direction parallel to the first direction.
Clause 25. The method of any of clauses 18 to 24, comprising: projecting a plurality of the beams onto the sample surface as a beam grid; and using the offset information generated for assessing the common portion corresponding to the first pair of the plurality of pairs of row data set and column data set for one of the beams of the beam grid to assess a common portion corresponding to a pair of a plurality of pairs of row data set and column data set for a different one of the beams of the beam grid.
Clause 26. The method of any of clauses 14 to 25, comprising projecting a plurality of the beams onto the sample surface as a beam grid.
Clause 27. The method of clause 26, comprising assessing a plurality of the assessment regions using respective beams of the beam grid.
Clause 28. The method of clause 27, wherein the assessing of the plurality of assessment regions is performed by relative scanning of respective beams of the beam grid over the assessment regions.
Clause 29. The method of clause 28, wherein the relative scanning comprises: mechanical scanning of the beam grid over the sample surface by relative movement between the sample surface and a charged particle-optical element projecting the beam grid towards the sample surface; and electromagnetic scanning of the beams of the beam grid over respective assessment regions.
Clause 30. The method of clause 29, wherein an area of a unit cell of the beam grid where the beam grid intersects with the sample surface is substantially equal to an area of each assessment region or substantially equal to an integer multiple of the area of each assessment region.
Clause 31. The method of any preceding clause, wherein the processing comprises identifying candidate defects in the intended pattern in the first region or second region.
Clause 32. A computer-implemented method of assessing a sample surface, comprising: receiving a row data set generated from, at a first region of a sample surface on which is an intended pattern, relative scanning a beam of charged particles over an elongate row portion of the intended pattern along a first direction; receiving a column data set generated from, at a second region of the sample surface on which is a repeat of the intended pattern, relative scanning the beam over an elongate column portion of the intended pattern along a second direction, the first and second directions being angled relative to each other; processing the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.
Clause 33. A computer-readable medium, optionally non-transitory, comprising instructions which, when executed by a computer, cause the computer to carry out the method of clause 32.
Clause 34. An apparatus for assessing a sample surface, the apparatus comprising: a charged particle-optical device configured to direct a charged particle beam towards the sample surface of a sample, the charged particle-optical device being actuatable to electromagnetically scan the beam over the sample surface; a sample support configured to support the sample, the sample support being actuatable to provide relative movement between the sample support and the charged-particle-optical device; a controller; a detector; and a data processing device, wherein: the controller is configured to control the charged particle-optical device and the sample support to: at a first region of the sample surface on which is an intended pattern, perform relative scanning of the beam over an elongate row portion of the intended pattern along a first direction, and at a second region of the sample surface on which is a repeat of the intended pattern, relative scanning the beam over an elongate column portion of the intended pattern along a second direction, the first and second directions being angled relative to each other; the detector is configured to: generate a row data set by detecting signal charged particles emitted from the sample surface during the relative scanning of the beam over the row portion, and generate a column data set by detecting signal charged particles emitted from the sample surface during the relative scanning of the beam over the column portion; and the data processing device is configured to: process the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.
Clause 35. A method of scanning a sample surface using a charged particle beam directed towards the sample surface, the method comprising: at a first region of a sample surface, relative scanning a beam over a plurality of row portions; and at a second region of the sample surface, relative scanning the beam over a plurality of column portions, wherein: the row portions are aligned perpendicularly or obliquely relative to the column portions.
Clause 36. The method of clause 35, wherein the first region and the second region are adjoining or separated from each other, optionally wherein the first region is at least part of a first die and the second region is at least part of a second die, or at least a portion of the first region and at least a portion of the second region are in the same die.
Clause 37. The method of clause 35 or 36, wherein: the relative scanning of the beam over the row portions comprises mechanical scanning, the mechanical scanning comprising providing relative movement between the sample surface and a charged particle-optical device directing the beam towards the sample surface, parallel to a first direction, desirably at least partly by actuating a sample support supporting the sample to move the sample parallel to the first direction; and the relative scanning of the beam over the column portions comprises mechanical scanning, the mechanical scanning comprising providing relative movement between the sample surface and the charged particle-optical device, parallel to a second direction, desirably at least partly by actuating the sample support to move the sample parallel to the second direction.
Clause 38. The method of clause 37, wherein: the relative scanning of the beam over the row portions comprises electromagnetic scanning of the beam, the electromagnetic scanning optionally comprising electromagnetic scanning substantially perpendicularly to the first direction, substantially parallel to the first direction, and/or substantially at 45 degrees to the first direction; and the relative scanning of the beam over the column portions of the intended pattern comprises electromagnetic scanning of the beam, the electromagnetic scanning optionally comprising electromagnetic scanning substantially perpendicularly to the second direction, substantially parallel to the second direction, and/or substantially at 45 degrees to the second direction.
Clause 39. The method of the clause 38, wherein the relative scanning of the beam over the row portions and the relative scanning of the beam over the column portions comprise electromagnetic scanning of the beam in a common direction and/or electromagnetic scanning such that an average direction of the electromagnetic scanning during the relative scanning of the beam over the row portions is within a range of +/- 20 degrees of an average direction of the electromagnetic scanning during the relative scanning of the beam over the column portions.
Clause 40. The method of clause 38 or 39, wherein the mechanical scanning is slower than the electromagnetic scanning and/or the electromagnetic scanning has a smaller range than the mechanical scanning.
Clause 41. A charged particle assessment apparatus for assessing a sample by directing a plurality of charged particle beams towards the sample surface, the charged particle apparatus comprising: a sample support configured to support a sample; a charged particle device configured to direct a plurality of primary beams of charged particles arranged in a beam grid towards a region of a sample surface of the sample; and a controller configured to control relative motion between the plurality of beams and the sample surface so as to scan the beams over the region and to move the relative position between the sample surface and the beam grid so that the primary beams of the beam grid scan different regions, wherein the controller is configured to control the sample support to move in different directions across the beam grid when the primary beams of the beam grid scan a different region.
Clause 42. The apparatus of clause 41, wherein different primary beams are assigned different beam processable regions within the region.
Clause 43. The apparatus of clause 41 or 42, further comprising a detector array comprising a detector element for detecting signal particles emitted by the sample surface in response to the primary beams incident on the sample, desirably wherein the detector element transmits a detection signal on detection of a signal particle.
Clause 44. The apparatus of any of clauses 41 to 43, wherein the relative motion at a first region of the different regions is in a first direction, desirably the detection signal representing a row data set, such as a row image.
Clause 45. The apparatus of any of clauses 41 to 44, wherein the relative motion at a second region of the different regions is in a second direction, desirably the detection signal representing a column data set, such as a column image.
Clause 46. The apparatus of any of clauses 41 to 45, wherein the first and second directions are angled, preferably perpendicular, to each other.
Clause 47. The apparatus of any of clauses 41 to 46, wherein the charged particle device is configured to perform electromagnetic scanning of the beams during the movement of the sample support in one or more fast scan directions, the fast scan directions comprising substantially parallel to the movement of the sample support, substantially perpendicular to the movement of the sample support, and/or at substantially 45 degrees to the movement of the sample support.
Clause 48. The apparatus of any of clauses 41 to 47, configured to compare data sets represented by detector signals from detector elements, the detector signals generated from scanning at least part of the different regions.:

## Claims

1. A method of assessing a sample surface using a charged particle beam directed towards the sample surface, the method comprising:
at a first region of a sample surface on which is an intended pattern, relative scanning a beam over an elongate row portion of the intended pattern along a first direction;
generating a row data set by detecting signal charged particles emitted from the sample surface during the relative scanning of the beam over the row portion;
at a second region of the sample surface on which is a repeat of the intended pattern, relative scanning the beam over an elongate column portion of the intended pattern along a second direction, the first and second directions being angled relative to each other;
generating a column data set by detecting signal charged particles emitted from the sample surface during the relative scanning of the beam over the column portion; and
processing the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.

2. The method of claim 1, wherein the first region and the second region are adjoining or separated from each other.

3. The method of claim 1 or 2, wherein the first region is at least part of a first die and the second region is at least part of a second die, or at least a portion of the first region and at least a portion of the second region are in the same die.

4. The method of any preceding claim, wherein the first direction is perpendicular or oblique to the second direction.

5. The method of any preceding claim, wherein the processing the row data set and the column data set comprises aligning the common portion of the intended pattern in the row data set with the common portion of the intended pattern in the column data set to compare the common portions.

6. The method of claim 5, comprising:
processing the row data set to generate a row image, the row image being an image of the row portion of the intended pattern; and
processing the column data set to generate a column image, the column image being an image of the column portion of the intended pattern.

7. The method of claim 6, wherein the aligning of the common portions comprises adjusting a position of the row image relative to the column image in a direction parallel to the first direction and/or adjusting a position of the column image relative to the row image in a direction parallel to the second direction.

8. The method of any preceding claim, wherein:
the relative scanning of the beam over the row portion of the intended pattern comprises mechanical scanning, the mechanical scanning comprising providing relative movement between the sample surface and a charged particle-optical device directing the beam towards the sample surface, parallel to the first direction, desirably at least partly by actuating a sample support supporting the sample to move the sample parallel to the first direction; and
the relative scanning of the beam over the column portion of the intended pattern comprises mechanical scanning, the mechanical scanning comprising providing relative movement between the sample surface and the charged particle-optical device, parallel to the second direction, desirably at least partly by actuating the sample support to move the sample parallel to the second direction.

9. The method of claim 8, wherein:
the relative scanning of the beam over the row portion of the intended pattern comprises electromagnetic scanning of the beam,; and
the relative scanning of the beam over the column portion of the intended pattern comprises electromagnetic scanning of the beam, the electromagnetic scanning.

10. The method of claim 9, wherein the relative scanning of the beam over the row portion of the intended pattern and the relative scanning of the beam over the column portion of the intended pattern comprise electromagnetic scanning of the beam in a common direction and/or electromagnetic scanning such that an average direction of the electromagnetic scanning during the relative scanning of the beam over the row portion is within a range of +/- 20 degrees of an average direction of the electromagnetic scanning during the relative scanning of the beam over the column portion.

11. The method of any of claims 8 to 10, wherein the mechanical scanning is slower than the electromagnetic scanning and/or the electromagnetic scanning has a smaller range than the mechanical scanning.

12. The method of any preceding claim, wherein:
the relative scanning at the first region is repeated for a plurality of different row portions of the intended pattern in the first region to generate a corresponding plurality of the row data sets;
the relative scanning at the second region is repeated for a plurality of different column portions of the intended pattern in the second region to generate a corresponding plurality of column data sets; and
the method comprises assessing an assessment region by assessing common portions corresponding to a plurality of pairs of row data set and column data set.

13. The method of any of claim 12, wherein assessing a common portion corresponding to a first pair of the plurality of pairs comprises generating offset information defining how to align the common portion of the intended pattern in the row data set of the first pair with the common portion of the intended pattern in the column data set of the first pair, to compare the common portions of the first pair.

14. The method of claim 12 or 13, comprising projecting a plurality of the beams onto the sample surface as a beam grid and assessing a plurality of the assessment regions using respective beams of the beam grid.

15. An apparatus for assessing a sample surface, the apparatus comprising:
a charged particle-optical device configured to direct a charged particle beam towards the sample surface of a sample, the charged particle-optical device being actuatable to electromagnetically scan the beam over the sample surface;
a sample support configured to support the sample, the sample support being actuatable to provide relative movement between the sample support and the charged-particle-optical device;
a controller;
a detector; and
a data processing device, wherein:
the controller is configured to control the charged particle-optical device and the sample support to:
at a first region of the sample surface on which is an intended pattern, perform relative scanning of the beam over an elongate row portion of the intended pattern along a first direction, and
at a second region of the sample surface on which is a repeat of the intended pattern, relative scanning the beam over an elongate column portion of the intended pattern along a second direction, the first and second directions being angled relative to each other;
the detector is configured to:
generate a row data set by detecting signal charged particles emitted from the sample surface during the relative scanning of the beam over the row portion, and
generate a column data set by detecting signal charged particles emitted from the sample surface during the relative scanning of the beam over the column portion; and
the data processing device is configured to:
process the row data set and the column data set to compare between the row data set and the column data set a common portion of the intended pattern, the common portion being common to both the row portion of the intended pattern and the column portion of the intended pattern, and thereby assessing the common portion of either or both of the row portion and the column portion.
